# EUROPEAN PATENT APPLICATION

(11) **EP 4 657 418 A1**
(43) Date of publication of application: **03.12.2025**
(21) Application number: 24881270.3
(22) Date of filing: 03.09.2024
(51) Int. Cl.: G09G 3/20, G09G 3/36

(54) **SHIFT REGISTER, GATE DRIVE CIRCUIT, AND DISPLAY DEVICE**

(30) Priority: 25.10.2023 CN 202311395010; 11.07.2024 CN 202410931046
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: WANG, Benlian, Beijing 100176 (CN); GUO, Yonglin, Beijing 100176 (CN); YU, Ziyang, Beijing 100176 (CN); ZHENG, Hai, Beijing 100176 (CN); LIU, Miao, Beijing 100176 (CN); YAO, Xing, Beijing 100176 (CN)
(74) Representative: Cohausz & Florack
(86) International application number: PCT/CN2024/116496
(87) International publication number: WO 2025/086903

(57) **Abstract**

The present disclosure provides a shift register, a gate driver circuit and a display apparatus, and belongs to the field of display technology. The shift register of the present disclosure includes an input sub-circuit configured to control potentials of first and second nodes in response to first and second clock signals provided via first and second clock signal lines, respectively; a first control sub-circuit configured to control the potential of the first node in response to a signal of the second node and a third clock signal provided via a third clock signal line; a second control sub-circuit configured to control a potential of a third node in response to a signal of the first node, the signal of the second node, and a fourth clock signal provided via a fourth clock signal line; and an output sub-circuit configured to output a first output signal in response to the signal of the first node, or output a second output signal in response to the signal of the third node.

## Description

### TECHNICAL FIELD

The present disclosure relates to the field of display technology, and specifically relates to a shift register, a gate driver circuit and a display apparatus.

### BACKGROUND

In the field of display technology, an array of pixels of, for example, a liquid crystal display panel or an organic light-emitting diode (OLED) display panel generally includes multiple rows of gate lines and multiple columns of data lines crossing the gate lines. The driving of gate lines may be implemented by a bound integrated driver circuit.

The gate drive on array (GOA) technology is a commonly used technology in current display panels, in which a line scan drive signal circuit is formed on an array substrate to implement a drive mode for progressive scanning of gate lines. Currently, with the increasing requirement of the existing display products on resolution, more and more transmission stages of shift registers are provided in the gate driver circuit integrated in the display products of higher resolution, which may increase the capacitance and resistance loads of clock signal lines and power signal lines, and influence the display image.

### SUMMARY

To solve at least one of the technical problems in the existing art, the present disclosure provides a shift register, a gate driver circuit and a display apparatus.

In a first aspect, a technical solution adopted to solve the technical problem of the present disclosure is a shift register, including a first clock signal line, a second clock signal line, a third clock signal line, a fourth clock signal line, an input sub-circuit, a first control sub-circuit, a second control sub-circuit, and an output sub-circuit; wherein
the input sub-circuit is configured to control potentials of a first node and a second node in response to a first clock signal provided via the first clock signal line and a second clock signal provided via the second clock signal line;
the first control sub-circuit is configured to control the potential of the first node in response to a signal of the second node and a third clock signal provided via the third clock signal line;
the second control sub-circuit is configured to control a potential of a third node in response to a signal of the first node, the signal of the second node, and a fourth clock signal provided via the fourth clock signal line; and
the output sub-circuit is configured to output a first output signal in response to the signal of the first node, or output a second output signal in response to the signal of the third node.

In some embodiments, in one clock cycle, the first clock signal has a pulse preceding a pulse of the second clock signal, the second clock signal has the pulse preceding a pulse of the third clock signal, and the third clock signal has the pulse preceding a pulse of the fourth clock signal.

In some embodiments, in one clock cycle, the first clock signal has a pulse preceding a pulse of the second clock signal, the second clock signal has the pulse preceding a pulse of the fourth clock signal, and the fourth clock signal has the pulse preceding a pulse of the third clock signal.

In some embodiments, the first clock signal has the same timing as the second clock signal; the third clock signal has an opposite timing to the first clock signal; and the fourth clock signal has the same timing as the third clock signal.

In some embodiments, the first clock signal and the second clock signal each include a first level; and the first level of the first clock signal has a different potential from the first level of the second clock signal; and/or,
the third clock signal and the fourth clock signal each include a third level; and the third level of the third clock signal has a different potential from the third level of the fourth clock signal.

In some embodiments, the first level of the first clock signal has a potential lower than the first level of the second clock signal; and/or,
the third level of the third clock signal has a potential lower than the third level of the fourth clock signal.

In some embodiments, the first clock signal and the second clock signal each further include a second level different from the first level; and the second level of the first clock signal has a different potential from the second level of the second clock signal; and/or,
the third clock signal and the fourth clock signal each further include a fourth level different from the third level; and the fourth level of the third clock signal has a different potential from the fourth level of the fourth clock signal.

In some embodiments, the second level of the first clock signal has a potential higher than the second level of the second clock signal; and/or,
the fourth level of the third clock signal has a potential higher than the fourth level of the fourth clock signal.

In some embodiments, the shift register further includes a first power signal line, a second power signal line, a third power signal line, and a fourth power signal line; wherein
the input sub-circuit is electrically connected to the first power signal line, the first control sub-circuit is electrically connected to the third power signal line, the second control sub-circuit is electrically connected to the fourth power signal line, and the output sub-circuit is electrically connected to the second power signal line and the third power signal line.

In some embodiments, a first power signal transmitted via the first power signal line has a potential lower than a second power signal transmitted via the second power signal line; a third power signal transmitted via the third power signal line has a potential lower than a fourth power signal transmitted via the fourth power signal line; and the second power signal has a potential lower than the third power signal.

In some embodiments, the first level of the first clock signal has a potential equal to the first power signal, and the second level of the first clock signal has a potential equal to the fourth power signal;
the first level of the second clock signal has a potential equal to the second power signal, and the second level of the second clock signal has a potential equal to the third power signal;
the third level of the third clock signal has a potential equal to the first power signal, and the fourth level of the third clock signal has a potential equal to the fourth power signal; and
the third level of the fourth clock signal has a potential equal to the second power signal, and the third level of the fourth clock signal has a potential equal to the third power signal.

In some embodiments, the first clock signal has a smaller pulse width for the first level than for the second level; and/or, the third clock signal has a smaller pulse width for the third level than for the fourth level.

In some embodiments, the input sub-circuit includes a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line.

In some embodiments, the input sub-circuit includes a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the first clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line.

In some embodiments, the input sub-circuit includes a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the first clock signal line.

In some embodiments, the shift register further includes an isolation sub-circuit;
the isolation sub-circuit is configured to isolate the first node from the first control sub-circuit electrically connected to the first node; isolate the first node from the output sub-circuit electrically connected to the first node; and isolate the second node from the second control sub-circuit electrically connected to the second node; and
the first control sub-circuit is electrically connected to a fifth node; the output sub-circuit is electrically connected to the fifth node; and the second control sub-circuit is electrically connected to a fourth node.

In some embodiments, the isolation sub-circuit includes an eleventh transistor and a twelfth transistor; wherein
the eleventh transistor has a first electrode electrically connected to the second node, a second electrode electrically connected to the fourth node, and a control electrode electrically connected to a first power signal line; and
the twelfth transistor has a first electrode electrically connected to the first node, a second electrode electrically connected to the fifth node, and a control electrode electrically connected to a second power signal line.

In some embodiments, the isolation sub-circuit includes an eleventh transistor and a twelfth transistor; wherein
the eleventh transistor has a first electrode electrically connected to the second node, a second electrode electrically connected to the fourth node, and a control electrode electrically connected to a first power signal line; and
the twelfth transistor has a first electrode electrically connected to the first node, a second electrode electrically connected to the fifth node, and a control electrode electrically connected to a first power signal line.

In some embodiments, the first control sub-circuit includes a fourth transistor, a fifth transistor, and a third capacitor;
the fourth transistor has a first electrode electrically connected to the third clock signal line, a second electrode electrically connected to a second electrode of the fifth transistor, and a control electrode electrically connected to the fifth node;
the fifth transistor has a first electrode electrically connected to a third power signal line, the second electrode electrically connected to a first plate of the third capacitor, and a control electrode electrically connected to the second node; and
the third capacitor has a second plate electrically connected to the fifth node.

In some embodiments, the second control sub-circuit includes a sixth transistor, a seventh transistor, an eighth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line; and
the eighth transistor has a first electrode electrically connected to a fourth power signal line, a second electrode electrically connected to the third node, and a control electrode electrically connected to the first node.

In some embodiments, the second control sub-circuit includes a sixth transistor, a seventh transistor, an eighth transistor, a thirteenth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the capacitor;
the seventh transistor has the first electrode electrically connected to a second plate of the first capacitor, a second electrode electrically connected to the third node, and a control electrode electrically connected to the fourth clock signal line;
the eighth transistor has a first electrode electrically connected to a fourth power signal line, a second electrode electrically connected to the third node, and a control electrode electrically connected to the first node; and
the thirteenth transistor has a first electrode electrically connected to the fourth power signal line, a second electrode electrically connected to the first node, and a control electrode electrically connected to a preset control terminal.

In some embodiments, the input sub-circuit includes a first transistor, a second transistor, a third transistor, and a fourteenth transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line; and
the fourteenth transistor has a first electrode electrically connected to a signal input, a second electrode electrically connected to an eighth node, and a control electrode electrically connected to the first clock signal line.

In some embodiments, the shift register further includes an isolation sub-circuit;
the isolation sub-circuit is configured to isolate the first node from the first control sub-circuit electrically connected to the first node; isolate the first node from the output sub-circuit electrically connected to the first node; isolate the first node from the second control sub-circuit electrically connected to the first node; and isolate the second node from the second control sub-circuit electrically connected to the second node; and
the first control sub-circuit is electrically connected to a fifth node; the output sub-circuit is electrically connected to the fifth node; and the second control sub-circuit is electrically connected to a fourth node and the fifth node.

In some embodiments, the input sub-circuit includes a first transistor, a second transistor, a third transistor, and a fourteenth transistor;
the first transistor has a first electrode electrically connected to a signal input, a second electrode electrically connected to the first node, and a control electrode electrically connected to the first clock signal line;
the second transistor has a first electrode electrically connected to the first clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line; and
the fourteenth transistor has a first electrode electrically connected to a signal input, a second electrode electrically connected to an eighth node, and a control electrode electrically connected to the second clock signal line.

In some embodiments, the first control sub-circuit includes a fourth transistor, a fifth transistor, a fifteenth transistor, a sixteenth transistor, and a third capacitor;
the fourth transistor has a first electrode electrically connected to the third clock signal line, a second electrode electrically connected to a second electrode of the fifth transistor, and a control electrode electrically connected to a second plate of the third capacitor;
the fifth transistor has a first electrode electrically connected to a third power signal line, the second electrode electrically connected to a first plate of the third capacitor, and a control electrode electrically connected to the second node;
the fifteenth transistor has a first electrode electrically connected to the eighth node, a second electrode electrically connected a first electrode and a control electrode of the sixteenth transistor, and a control electrode electrically connected to a first power signal line; and
the sixteenth transistor has a second electrode electrically connected to the fifth node, and the control electrode electrically connected to the control electrode of the fourth transistor.

In some embodiments, the second control sub-circuit includes a sixth transistor, a seventh transistor, an eighth transistor, a thirteenth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line;
the eighth transistor has a first electrode electrically connected to a fourth power signal line, a second electrode electrically connected to the third node, and a control electrode electrically connected to the fifth node; and
the thirteenth transistor has a first electrode electrically connected to the fourth power signal line, a second electrode electrically connected to the fifth node, and a control electrode electrically connected to a preset control terminal.

In some embodiments, the output sub-circuit includes a ninth transistor, a tenth transistor, and a second capacitor;
the ninth transistor has a first electrode electrically connected to a third power signal line and a first plate of the second capacitor, a second electrode electrically connected to a signal output, and a control electrode electrically connected to the third node;
the tenth transistor has a first electrode electrically connected to a second power signal line, a second electrode electrically connected to the signal output, and a control electrode electrically connected to the fifth node; and
the second capacitor has a second plate electrically connected to the third node.

In a second aspect, an embodiment of the present disclosure further provides a gate driver circuit, including N cascaded shift registers; wherein except for a first stage shift register, a signal input of an (i+1)^{th} stage shift register is electrically connected to a signal output of an i^{th} stage shift register, where n is a positive integer greater than 1, and i is a positive integer less than or equal to N.

In some embodiments, a first clock signal line in the i^{th} stage shift register is multiplexed as a fourth clock signal line in the (i+1)^{th} stage shift register, a second clock signal line in the i^{th} stage shift register is multiplexed as a first clock signal line in the (i+1)^{th} stage shift register, a third clock signal line in the i^{th} stage shift register is multiplexed as a second clock signal line in the (i+1)^{th} stage shift register, and a fourth clock signal line in the i^{th} stage shift register is multiplexed as a third clock signal line in the (i+1)^{th} stage shift register.

In some embodiments, a first clock signal line in the i^{th} stage shift register is multiplexed as a third clock signal line in the (i+1)^{th} stage shift register, a second clock signal line in the i^{th} stage shift register is multiplexed as a fourth clock signal line in the (i+1)^{th} stage shift register, a third clock signal line in the i^{th} stage shift register is multiplexed as a first clock signal line in the (i+1)^{th} stage shift register, and a fourth clock signal line in the i^{th} stage shift register is multiplexed as a second clock signal line in the (i+1)^{th} stage shift register.

In a third aspect, an embodiment of the present disclosure further provides a display apparatus, including a pixel driver circuit and a gate driver circuit according to the second aspect, wherein the gate driver circuit is electrically connected to the pixel driver circuit to provide a gate control signal for the pixel driver circuit.

### BRIEF DESCRIPTION OF DRAWINGS

FIG. 1 is a schematic structural diagram of a shift register according to an embodiment of the present disclosure;
FIG. 2 is a timing diagram of clock signal lines in one clock cycle in a first example according to an embodiment of the present disclosure;
FIG. 3 is a timing diagram of clock signal lines in one clock cycle in a second example according to an embodiment of the present disclosure;
FIG. 4 is a timing diagram of clock signal lines in one clock cycle in a third example according to an embodiment of the present disclosure;
FIG. 5a is a schematic structural diagram of another shift register according to an embodiment of the present disclosure;
FIG. 5b is a schematic structural diagram of another shift register according to an embodiment of the present disclosure;
FIG. 6 is a circuit diagram of a 12T3C circuit structure according to an embodiment of the present disclosure;
FIG. 7 is a circuit diagram of another 12T3C circuit structure according to an embodiment of the present disclosure;
FIG. 8 is a circuit diagram of a 13T3C circuit structure according to an embodiment of the present disclosure;
FIG. 9 is a circuit diagram of another 13T3C circuit structure according to an embodiment of the present disclosure;
FIG. 10 is a schematic structural diagram of another shift register according to an embodiment of the present disclosure;
FIG. 11 is a circuit diagram of a 16T3C circuit structure according to an embodiment of the present disclosure;
FIG. 12 is a circuit diagram of another 16T3C circuit structure according to an embodiment of the present disclosure;
FIG. 13 is a timing diagram of an exemplary shift register according to an embodiment of the present disclosure;
FIG. 14 is a timing diagram of another exemplary shift register according to an embodiment of the present disclosure;
FIG. 15 is a timing diagram of another exemplary shift register according to an embodiment of the present disclosure;
FIG. 16 is a schematic diagram of a gate driver circuit according to an embodiment of the present disclosure;
FIG. 17 is a schematic diagram of another gate driver circuit according to an embodiment of the present disclosure;
FIG. 18 is a circuit diagram of cascaded shift registers with the 12T3C circuit structure of FIG. 6 according to an embodiment of the present disclosure;
FIG. 19 is a circuit diagram of cascaded shift registers with the 13T3C circuit structure of FIG. 8 according to an embodiment of the present disclosure;
FIG. 20 is a circuit diagram of cascaded shift registers with the 16T3C circuit structure of FIG. 11 according to an embodiment of the present disclosure;
FIG. 21 is a circuit diagram of cascaded shift registers with the 12T3C circuit structure of FIG. 7 according to an embodiment of the present disclosure;
FIG. 22 is a circuit diagram of cascaded shift registers with the 13T3C circuit structure of FIG. 9 according to an embodiment of the present disclosure; and
FIG. 23 is a circuit diagram of cascaded shift registers with the 16T3C circuit structure of FIG. 12 according to an embodiment of the present disclosure.

### DETAIL DESCRIPTION OF EMBODIMENTS

To clarify the objects, technical solutions and advantages of the embodiments of the present disclosure, the technical solutions in the embodiments of the present disclosure will be clearly and completely described below with reference to the accompanying drawings in the embodiments of the present disclosure. Obviously, the described embodiments are merely some, not all, of the embodiments of the present disclosure. The components in the embodiments of the present disclosure, as generally described and illustrated in the figures herein, could be arranged and designed in a wide variety of different configurations. Therefore, the following detailed description of the embodiments of the present disclosure, provided in the accompanying drawings, is not intended to limit the scope of the present disclosure as claimed, but is merely representative of selected embodiments of the present disclosure. All other embodiments, which can be derived by those skilled in the art from the embodiments of the present disclosure without making any creative effort, shall fall within the protection scope of the present disclosure.

Unless otherwise defined, technical or scientific terms used in the present disclosure are intended to have general meanings as understood by those skilled in the art to which the present disclosure belongs. The words "first", "second" and similar terms used in the present disclosure do not denote any order, quantity, or importance, but are used merely for distinguishing different components from each other. Likewise, the words "a", "an", "the" and similar referents do not denote a limitation of quantity, but rather denote the presence of at least one. The word "comprise" or "include" or the like means that the element or item preceding the word contains elements or items that appear after the word or equivalents thereof, but does not exclude other elements or items.

Reference to "a plurality of or several" in the present disclosure means two or more. The term "and/or" describes an association relationship of associated objects, which may include three relationships; for example, A and/or B may refer to: A alone, A and B, or B alone. The character "/" generally indicates that the former and latter associated objects are in an "or" relationship.

In the existing art, a set of clock signals of opposite timings are coupled to a shift register, while clock signals of the same timing are transmitted via the same clock signal line. For a display product of higher resolution, more transmission stages of shift registers in the gate driver circuit integrated therein means higher capacitance and resistance loads on the same clock signal line, and thus prolonged time for each shift register to output a signal, thereby affecting the effective working time of pixels as well as the display image. Meanwhile, more transmission stages of shift registers in the gate driver circuit also means more transistors coupled to the same clock signal line, as well as a higher parasitic capacitance, thereby further influencing the display image. In addition, more transmission stages of shift registers in the gate driver circuit also means more transistors coupled to the same power signal line, as well as an increased load, which may cause fluctuations in the power signal transmitted via the power signal line, and finally defects, such as fine horizontal stripes, in the display image, thereby influencing the display effect.

In view of this, an embodiment of the present disclosure provides a shift register, including a first clock signal line, a second clock signal line, a third clock signal line, a fourth clock signal line, an input sub-circuit, a first control sub-circuit, a second control sub-circuit, and an output sub-circuit. The input sub-circuit is configured to control potentials of a first node and a second node in response to a first clock signal provided via a first clock signal line and a second clock signal provided via a second clock signal line. The first control sub-circuit is configured to control the potential of the first node in response to a signal of the second node and a third clock signal provided via a third clock signal line. The second control sub-circuit is configured to control a potential of a third node in response to a signal of the first node, the signal of the second node, and a fourth clock signal provided via a fourth clock signal line. The output sub-circuit is configured to output a first output signal in response to the potential of the first node, or output a second output signal in response to the potential of the third node.

The shift register provided in the embodiment of the present disclosure includes a plurality of clock signal lines, i.e., a first clock signal line, a second clock signal line, a third clock signal line, and a fourth clock signal line, which are used for providing clock signals and dispersing the load on a single clock signal line in the existing art, so that the power consumption of the product is reduced while the display effect is improved.

The following provides a detailed description of the specific circuit structure of a shift register according to an embodiment of the present disclosure.

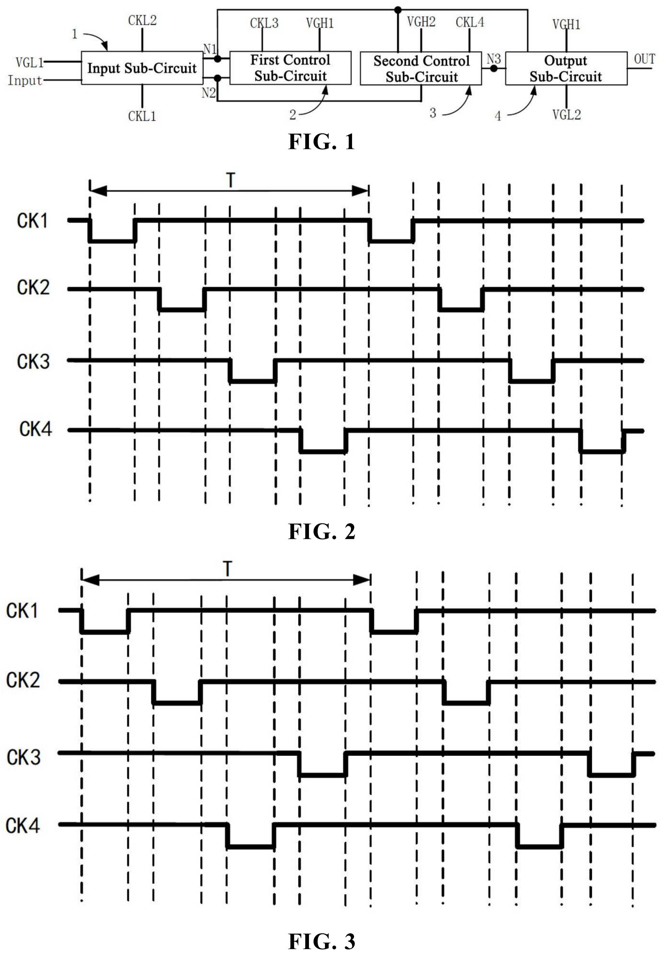

FIG. 1 is a schematic structural diagram of a shift register according to an embodiment of the present disclosure. As shown in FIG. 1, the shift register includes a first clock signal line CKL1, a second clock signal line CKL2, a third clock signal line CKL3, a fourth clock signal line CKL4, an input sub-circuit 1, a first control sub-circuit 2, a second control sub-circuit 3, and an output sub-circuit 4.

The input sub-circuit 1 is electrically connected to the first clock signal line CKL1, the second clock signal line CKL2, a first node N1, and a second node N2. On this basis, the input sub-circuit 1 is configured to control potentials of the first node N1 and the second node N2 in response to a first clock signal CK1 provided via the first clock signal line CKL1 and a second clock signal CK2 provided via the second clock signal line CKL2.

Illustratively, as shown in FIG. 1, the shift register further includes a signal input Input and a signal output OUT electrically connected to a signal input line and a pixel driver circuit, respectively. The signal input line is configured to provide an input signal. The shift register is configured to provide a gate line scan signal for the pixel driver circuit.

Illustratively, as shown in FIG. 1, the shift register further includes a first power signal line VGL1 configured to provide a first power signal. The input sub-circuit 1 in the shift register is electrically connected to the signal input Input and the first power signal line VGL1. The input sub-circuit 1 is configured to control, in response to the first clock signal CK1 and the second clock signal CK2, potentials of the first node N1 and the second node N2 based on the input signal and the first power signal.

As further shown in FIG. 1, the first control sub-circuit 2 is electrically connected to the third clock signal line CKL3, the first node N1 and the second node N2. On this basis, the first control sub-circuit 2 is configured to control the potential of the first node N1 in response to a signal of the second node N2 and a third clock signal CK3 provided via the third clock signal line CKL3.

Illustratively, as shown in FIG. 1, the shift register further includes a third power signal line VGH1 configured to provide a third power signal. The first control sub-circuit 2 in the shift register is electrically connected to the third power signal line VGH1. The first control sub-circuit 2 is configured to control, in response to the signal of the second node N2, the potential of the first node N1 according to the third clock signal CK3 and the third power signal.

As further shown in FIG. 1, the second control sub-circuit 3 is electrically connected to the first node N1, the second node N2, a third node N3, and the fourth clock signal line CKL4. On this basis, the second control sub-circuit 3 is configured to control a potential of a third node N3 in response to a signal of the first node N1, the signal of the second node N2, and a fourth clock signal CK4 provided via the fourth clock signal line CKL4.

Illustratively, as shown in FIG. 1, the shift register further includes a fourth power signal line VGH2 configured to provide a fourth power signal. The second control sub-circuit 3 in the shift register is electrically connected to the fourth power signal line VGH2. The second control sub-circuit 3 is configured to control, in response to the signal of the first node N1, the signal of the second node N2, and the fourth clock signal CK4, the potential of the third node N3 according to the fourth clock signal CK4 and the fourth power signal.

As further shown in FIG. 1, the output sub-circuit 4 is electrically connected to the first node N1 and the third node N3. On this basis, the output sub-circuit 4 is configured to output a first output signal in response to the signal of the first node N1, or output a second output signal in response to a signal of the third node N3.

Illustratively, as shown in FIG. 1, the shift register further includes a second power signal line VGL2 configured to provide a second power signal. The output sub-circuit 4 in the shift register is electrically connected to the second power signal line VGL2 and the third power signal line VGH1. The output sub-circuit 4 is configured to output, in response to the signal of the first node N1, the first output signal according to the second power signal. Alternatively, the output sub-circuit 4 is configured to output, in response to the signal of the third node N3, the second output signal according to the third power signal.

Each of the first output signal and the second output signal may be both used as a gate line scan signal for the pixel driver circuit, or as an input signal for a next stage shift register cascaded with a current stage shift register.

Illustratively, the input signal is a pulse signal; while the first output signal is a low-level signal, and the second output signal is a high-level signal.

Illustratively, the first power signal line VGL1 and the second power signal line VGL2 are the same, and different from the third power signal line VGH1 and the fourth power signal line VGH2. In other words, the first power signal and the second power signal are the same, and may be transmitted via the same power signal line.

Illustratively, the third power signal line VGH1 and the fourth power signal line VGH2 are the same, and different from the first power signal line VGL1 and the second power signal line VGL2. In other words, the third power signal and the fourth power signal are the same, and may be transmitted via the same power signal line.

Illustratively, the first power signal line VGL1, the second power signal line VGL2, the third power signal line VGH1, and the fourth power signal line VGH2 are all different from each other. In this case, the first power signal and the second power signal may be the same, and the third power signal and the fourth power signal may be the same, but these signals are transmitted via different power signal lines.

Illustratively, in the case where the first power signal line VGL1, the second power signal line VGL2, the third power signal line VGH1, and the fourth power signal line VGH2 are all different from each other, the first power signal and the second power signal may be the same or different. The third power signal and the fourth power signal may be the same or different. However, the potential of each of the first power signal and the second power signal is lower than the potential of each of the third power signal and the fourth power signal.

The shift register provided in the embodiment of the present disclosure includes a plurality of clock signal lines, i.e., a first clock signal line, a second clock signal line, a third clock signal line, and a fourth clock signal line, which are used for providing clock signals and dispersing the load on a single clock signal line in the existing art, so that the number of transistors coupled to a single clock signal line can be reduced to shorten the signal output time, and the power consumption of the product can be saved while promoting uniform image quality across a large-screen display. In addition, the same power signal (e.g., the first power signal and the second power signal) may be transmitted via the same power signal line (which means that the first power signal line VGL1 and the second power signal line VGL2 are the same). For another example the third power signal and the fourth power signal may be transmitted via the same power signal line (which means that the third power signal line VGH1 and the fourth power signal line VGH2 are the same). In this manner, the layout space of signal lines can be reduced, and a narrow bezel can be promoted. Alternatively, the same power signal may be transmitted via different power signal lines. For example, the first power signal and the second power signal may be transmitted via different power signal lines, i.e., the first power signal line VGL1 and the second power signal line VGL2; and the third power signal and the fourth power signal may be transmitted via different power signal lines, i.e., the third power signal line VGH1 and the fourth power signal line VGH2. In this manner, signal fluctuations caused by an excess load on a single power signal line can be avoided, thereby improving the stability of signal output.

In some embodiments, FIG. 2 is a timing diagram of clock signal lines in one clock cycle in a first example according to an embodiment of the present disclosure. As shown in FIG. 2, in one clock cycle T, the first clock signal has a pulse preceding a pulse of the second clock signal, the second clock signal has the pulse preceding a pulse of the third clock signal, and the third clock signal has the pulse preceding a pulse of the fourth clock signal.

It should be noted that the "pulse" of a clock signal here refers to a trigger period of an active level of a clock signal, and in the present disclosure, taking the active level being a low level as an example, a low-level signal corresponding to a rising edge followed by a falling edge is referred to as a pulse of the clock signal.

Illustratively, active levels of the first, second, third and fourth clock signals have the same pulse width.

Illustratively, in one clock cycle T, a cutoff moment of the active level of the first clock signal may be used as a trigger moment of the active level of the second clock signal; a cutoff moment of the active level of the second clock signal may be used as a trigger moment of the active level of the third clock signal; and a cutoff moment of the active level of the third clock signal may be used as a trigger moment of the active level of the fourth clock signal.

Illustratively, in one clock cycle T, a preset time interval is provided between the cutoff moment of the active level of the first clock signal and the trigger moment of the active level of the second clock signal; a preset time interval is provided between the cutoff moment of the active level of the second clock signal and the trigger moment of the active level of the third clock signal; and a preset time interval is provided between the cutoff moment of the active level of the third clock signal and the trigger moment of the active level of the fourth clock signal. The preset time interval is less than a duration of the active level.

This embodiment adopts the clock signals of different timings, where timings of the first, second, third and fourth clock signals are sequentially changed, which, compared with the condition of same timing, can avoid signal mutation caused by simultaneous changes in timing, and thus prevent influences on the display effect.

In some embodiments, FIG. 3 is a timing diagram of clock signal lines in one clock cycle in a second example according to an embodiment of the present disclosure. As shown in FIG. 3, in one clock cycle T, the first clock signal has a pulse preceding a pulse of the second clock signal, the second clock signal has the pulse preceding a pulse of the fourth clock signal, and the fourth clock signal has the pulse preceding a pulse of the third clock signal.

Illustratively, in one clock cycle T, a cutoff moment of the active level of the first clock signal may be used as a trigger moment of the active level of the second clock signal; a cutoff moment of the active level of the second clock signal may be used as a trigger moment of the active level of the fourth clock signal; and a cutoff moment of the active level of the fourth clock signal may be used as a trigger moment of the active level of the third clock signal.

Illustratively, in one clock cycle T, a preset time interval is provided between the cutoff moment of the active level of the first clock signal and the trigger moment of the active level of the second clock signal; a preset time interval is provided between the cutoff moment of the active level of the second clock signal and the trigger moment of the active level of the fourth clock signal; and a preset time interval is provided between the cutoff moment of the active level of the fourth clock signal and the trigger moment of the active level of the third clock signal. The preset time interval is less than a duration of the active level.

This embodiment adopts the clock signals of different timings, where timings of the first, second, fourth and third clock signals are sequentially changed, which, compared with the condition of same timing, can avoid signal mutation caused by simultaneous changes in timing, and thus prevent influences on the display effect.

In some embodiments, as shown in FIG. 2 or 3, active levels of the first, second, third and fourth clock signals have the same potential, and inactive levels of the first, second, third and fourth clock signals have the same potential.

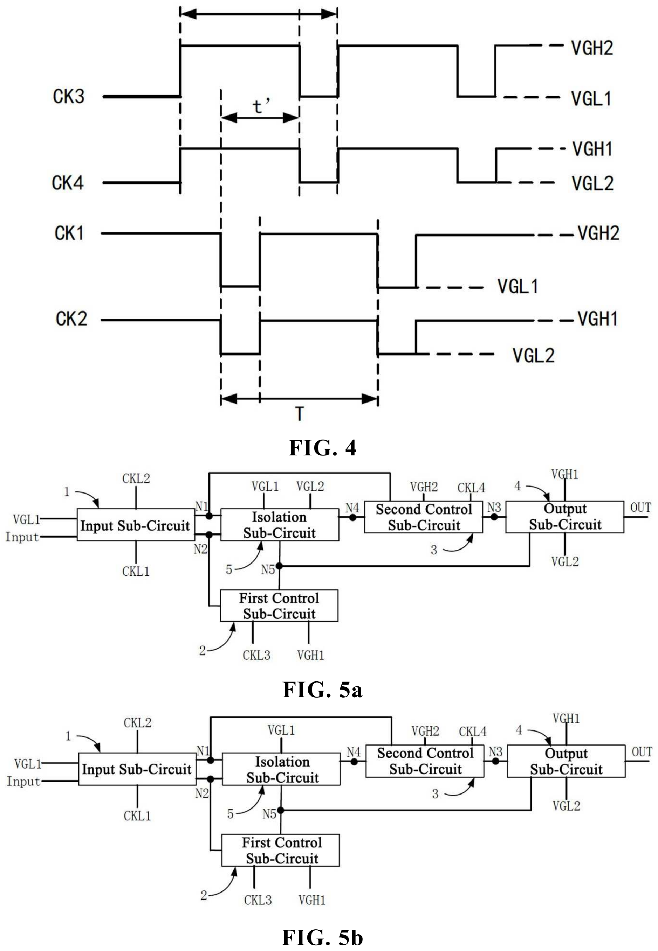

In some embodiments, FIG. 4 is a timing diagram of clock signal lines in one clock cycle in a third example according to an embodiment of the present disclosure. As shown in FIG. 4, the first clock signal CK1 has the same timing as the second clock signal CK2. The fourth clock signal CK4 has the same timing as the third clock signal CK3.

It should be noted that the timing in a circuit refers to a chronological order in which signals are switched between high and low potentials. The same timing means that the signals in comparison have the same potential transition time node, but does not mean that the signals have the same potential at the same time node.

As shown in FIG. 4, the third clock signal CK3 has an opposite timing to the first clock signal CK1. The opposite timing means that in the same clock cycle T, the signals in comparison have different potential transition time nodes. Alternatively, it may be interpreted as that the first clock signal CK1 and the third clock signal CK3 have the same signal waveform throughout the working scan phase, but the transition time node for the active level of the third clock signal CK3 is later than the transition time node for the active level of the first clock signal CK1 for a preset duration t'.

Here, the first clock signal line CKL1, the second clock signal line CKL2, the third clock signal line CKL3, and the fourth clock signal line CKL4 are all different from each other.

In the shift register of this embodiment, different clock signal lines, that is, the first clock signal line CKL1 and the second clock signal line CKL2, are used for transmitting the first clock signal CK1 and the second clock signal CK2 having the same timing, and the third clock signal line CKL3 and the fourth clock signal line CKL4 are used for transmitting the third clock signal CK3 and the fourth clock signal CK4 having the same timing, so that the number of transistors coupled to a single clock signal line, and thus the load on each clock signal line, can be reduced, thereby shortening the signal output time and promoting uniform image quality across a large-screen display.

In some embodiments, as shown in FIG. 4, the first clock signal CK1 and the second clock signal CK2 each include a first level; and the first level of the first clock signal CK1 has a different potential from the first level of the second clock signal CK2.

Illustratively, the first clock signal CK1 and the second clock signal CK2 have the same duration for the clock cycle T.

Illustratively, the first level is a low level (i.e., an active level) in the clock cycle T, and the low level of the first clock signal CK1 has a different potential from the low level of the second clock signal CK2. For example, the low level of the first clock signal CK1 may have a potential higher or lower than the low level of the second clock signal CK2.

Illustratively, an absolute value of an amplitude of the first clock signal CK1 is greater than an absolute value of an amplitude of the second clock signal CK2.

As further shown in FIG. 4, the third clock signal CK3 and the fourth clock signal CK4 each include a third level; and the third level of the third clock signal CK3 has a different potential from the third level of the fourth clock signal CK4.

Illustratively, the third clock signal CK3 and the fourth clock signal CK4 have the same duration for the clock cycle T.

Illustratively, as shown in FIG. 4the first clock signal CK1, the second clock signal CK2, the third clock signal CK3 and the fourth clock signal CK4 all have the same duration for the clock cycle T.

Illustratively, the third level is a low level (i.e., an active level) in the clock cycle T, and the low level of the third clock signal CK3 has a different potential from the low level of the fourth clock signal CK4. For example, the low level of the third clock signal CK3 may have a potential higher or lower than the low level of the fourth clock signal CK4.

Illustratively, an absolute value of an amplitude of the third clock signal CK3 is greater than an absolute value of an amplitude of the fourth clock signal CK4.

In some embodiments, as shown in FIG. 4, the first level of the first clock signal CK1 has a potential lower than the first level of the second clock signal CK2, so as to avoid the defect of hysteresis in at least some transistors in the input sub-circuit 1 which may affect characteristics of the transistors.

As further shown in FIG. 4, the third level of the third clock signal CK3 has a potential lower than the third level of the fourth clock signal CK4, so that the influence of threshold loss of at least some transistors in the first control sub-circuit 2 and the second control sub-circuit 3 is reduced.

In some embodiments, as shown in FIG. 4, the first clock signal CK1 and the second clock signal CK2 each further include a second level different from the first level; and the second level of the first clock signal CK1 has a different potential from the second level of the second clock signal CK2.

Illustratively, the second level is a high level (i.e., an inactive level) in the clock cycle T, and the high level of the first clock signal CK1 has a different potential from the high level of the second clock signal CK2. For example, the high level of the first clock signal CK1 may have a potential higher or lower than the high level of the second clock signal CK2.

As further shown in FIG. 4, the third clock signal CK3 and the fourth clock signal CK4 each further include a fourth level different from the third level; and the fourth level of the third clock signal CK3 has a different potential from the fourth level of the fourth clock signal CK4.

Illustratively, the fourth level is a high level (i.e., an inactive level) in the clock cycle T, and the high level of the third clock signal CK3 has a different potential from the high level of the fourth clock signal CK4. For example, the high level of the third clock signal CK3 may have a potential higher or lower than the high level of the fourth clock signal CK4.

In some embodiments, as shown in FIG. 4, the second level of the first clock signal CK1 has a potential higher than the second level of the second clock signal CK2; and/or, the fourth level of the third clock signal CK3 has a potential higher than the fourth level of the fourth clock signal CK4, so that the influence caused by threshold loss of some transistors in the shift register is reduced.

In some embodiments, the first power signal line VGL1, the second power signal line VGL2, the third power signal line VGH1, and the fourth power signal line VGH2 are all different from each other. The first power signal and the second power signal are both low-level signals, but have different potentials. The third power signal and the fourth power signal are both high-level signal, but have different potentials. A low-level signal has a potential lower than a high-level signal.

Illustratively, in consideration of the influence of threshold loss of some transistors in the shift register, the first power signal is set to a potential lower than the second power signal.

Illustratively, the third power signal has a potential lower than the fourth power signal, thereby improving the off characteristics of at least some transistors in the output sub-circuit 4.

In some embodiments, as shown in FIG. 4, the first level of the first clock signal CK1 has a potential equal to a first power signal transmitted via the first power signal line VGL1, and the second level of the first clock signal CK1 has a potential equal to a fourth power signal transmitted via the fourth power signal line VGH2. The first level of the second clock signal CK2 has a potential equal to a second power signal transmitted via the second power signal line VGL2, and the second level of the second clock signal CK2 has a potential equal to a third power signal transmitted via the third power signal line VGH1. The third level of the third clock signal CK3 has a potential equal to the first power signal transmitted via the first power signal line VGL1, and the fourth level of the third clock signal CK3 has a potential equal to the fourth power signal transmitted via the fourth power signal line VGH2. The third level of the fourth clock signal CK4has a potential equal to the second power signal transmitted via the second power signal line VGL2, and the fourth level of the fourth clock signal CK4has a potential equal to the third power signal transmitted via the third power signal line VGH1.

In some embodiments, as shown in FIG. 4, the first clock signal CK1 has a smaller pulse width for the first level than for the second level; and/or, the third clock signal CK3 has a smaller pulse width for the third level than for the fourth level.

Illustratively, the first level is a low level in the clock cycle T, and the second level is a high level in the clock cycle T. The first clock signal CK1 has a smaller pulse width for the low level than for the high level. The first clock signal CK1 and the second clock signal CK2 have the same duration for the clock cycle T. Therefore, the second clock signal CK2 has a smaller pulse width for the low level than for the high level.

Illustratively, the third level is a low level in the clock cycle T, and the fourth level is a high level in the clock cycle T. The third clock signal CK3 has a smaller pulse width for the low level than for the high level. The third clock signal CK3 and the fourth clock signal CK4 have the same duration for the clock cycle T. Therefore, the fourth clock signal CK4 has a smaller pulse width for the low level than for the high level.

When the pulse width is increased in this embodiment, the first node N1 (or fifth node N5) can be pulled down quickly to ensure quick output of the output signal as well as the display quality.

FIG. 5a is a schematic structural diagram of another shift register according to an embodiment of the present disclosure; and FIG. 5b is a schematic structural diagram of another shift register according to an embodiment of the present disclosure. In some embodiments, as shown in FIG. 5a, the shift register further includes an isolation sub-circuit 5. The isolation sub-circuit 5 is configured to isolate the first node N1 from the first control sub-circuit 2 electrically connected to the first node N1; isolate the first node N1 from the output sub-circuit 4 electrically connected to the first node N1; and isolate the second node N2 from the second control sub-circuit 3 electrically connected to the second node N2.

As shown in FIG. 5a, the first control sub-circuit 2 is electrically connected to a fifth node N5; the output sub-circuit 4 is electrically connected to the fifth node N5; and the second control sub-circuit 3 is electrically connected to a fourth node N4 and the first node N1.

As shown in FIG. 5a, the isolation sub-circuit 5 is electrically connected to the first node N1, the second node N2, the fourth node N4, the fifth node N5, the first power signal line VGL1, and the second power signal line VGL2. The isolation sub-circuit 5 is configured to communicate the first node N1 and the fifth node N5 in response to a second power signal; and communicate the second node N2 and the fourth node N4 in response to a first power signal.

Alternatively, as shown in FIG. 5b, the isolation sub-circuit 5 is electrically connected to the first node N1, the second node N2, the fourth node N4, the fifth node N5, and the first power signal line VGL1. The isolation sub-circuit 5 is configured to communicate the first node N1 and the fifth node N5, and communicate the second node N2 and the fourth node N4, in response to the first power signal.

In this embodiment, the isolation sub-circuit 5 is provided to improve stable output of the output signal.

The shift register may adopt a 12T3C (i.e., 12 transistors and 3 capacitors) circuit structure. Alternatively, the shift register may adopt a 13T3C (i.e., 13 transistors and 3 capacitors) circuit structure. Still alternatively, the shift register may adopt a 16T3C (i.e., 16 transistors and 3 capacitors) circuit structure.

It should be noted that each transistor in the embodiments of the present disclosure may be a thin film transistor or a field effect transistor or any other switch device with same characteristics. The thin film transistor may include an oxide semiconductor thin film transistor, an amorphous silicon thin film transistor, or a polysilicon thin film transistor, or the like. A source and a drain of the transistor may have no difference in physical structure since they are symmetrical in structure. In the embodiments of the present disclosure, for distinguishing purposes in the transistor, except a gate serving as a control electrode, one of the rest two electrodes is directly referred to as a first electrode and the other as a second electrode, and therefore, the first electrode and the second electrode of all or part of the transistors in the embodiments of the present disclosure may be exchangeable as needed.

It should be noted that the thin film transistor may be an N-type thin film transistor or a P-type thin film transistor. The N-type thin film transistor refers to a type in which N-type ion doping is performed on an active layer of the thin film transistor. The P-type thin film transistor refers to a type in which P-type ion doping is performed on an active layer of the thin film transistor. A working level signal of the N-type thin film transistor is a high-level signal; while a working level signal of the P-type thin film transistor is a low-level signal.

For convenience of understanding, the present disclosure is described in the following embodiments by taking the transistor being a P-type thin film transistor as an example, but the present disclosure is not limited thereto.

It should be noted that, in the embodiments of the present disclosure, besides the above listed structures of 12T3C, 13T3C, and 16T3C, the internal circuit structure of the shift register may include a structure including other numbers of transistors and capacitors, which is not limited in the embodiments of the present disclosure.

The shift registers of the 12T3C, 13T3C, and 16T3C circuit structures are described in detail below in combination with different embodiments, respectively.

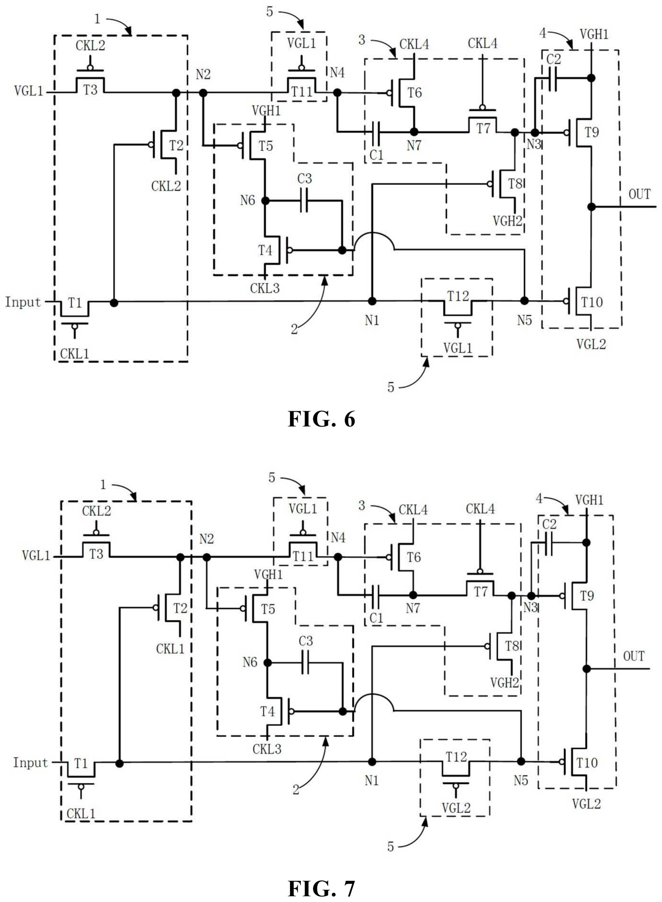

In some embodiments, a 12T3C circuit structure is taken as an example for illustration, and the 12T3C circuit structure adopts the timing control of clock signal lines shown in FIG. 2 or 3. FIG. 6 is a circuit diagram of a 12T3C circuit structure according to an embodiment of the present disclosure. As shown in FIG. 6, the input sub-circuit 1 includes a first transistor T1, a second transistor T2, and a third transistor T3. The first control sub-circuit 2 includes a fourth transistor T4, a fifth transistor T5, and a third capacitor C3. The second control sub-circuit 3 includes a sixth transistor T6, a seventh transistor T7, an eighth transistor T8, and a first capacitor C1. The output sub-circuit 4 includes a ninth transistor T9, a tenth transistor T10, and a second capacitor C2. The isolation sub-circuit 5 includes an eleventh transistor T11 and a twelfth transistor T12.

As further shown in FIG. 6, for the input sub-circuit 1, the first transistor T1 has a first electrode electrically connected to a signal input Input, a second electrode electrically connected to the first node N1, and a control electrode electrically connected to the first clock signal line CKL1; the second transistor T2 has a first electrode electrically connected to the second clock signal line CKL2, a second electrode electrically connected to the second node N2, and a control electrode electrically connected to the first node N1; and the third transistor T3 has a first electrode electrically connected to a first power signal line VGL1, a second electrode electrically connected to the second node N2, and a control electrode electrically connected to the second clock signal line CKL2. Specifically, the first clock signal CK1 may control on/off of the first transistor T1, and when the first transistor T1 is turned on in response to the first clock signal CK1, an input signal may be transmitted to the first node N1. The signal of the first node N1 may control on/off of the second transistor T2, and when the second transistor T2 is turned on in response to the signal of the first node N1, the second clock signal CK2 may be transmitted to the second node N2. The second clock signal CK2 may control on/off of the third transistor T3, and when the third transistor T3 is turned on in response to the second clock signal CK2, a first power signal may be transmitted to the second node N2.

Alternatively, for the input sub-circuit 1, the first electrode of the second transistor T2 may be electrically connected to the first clock signal line CKL1.

As further shown in FIG. 6, for the first control sub-circuit 2, the fourth transistor T4 has a first electrode electrically connected to the third clock signal line CKL3, a second electrode electrically connected to a second electrode of the fifth transistor T5, and a control electrode electrically connected to the fifth node N5; the fifth transistor T5 has a first electrode electrically connected to a third power signal line VGH1, the second electrode electrically connected to a first plate of the third capacitor C3, and a control electrode electrically connected to the second node N2; and the third capacitor C3 has a second plate electrically connected to the fifth node N5. Specifically, a signal of the fifth node N5 may control on/off of the fourth transistor T4, and when the fourth transistor T4 is turned on in response to the signal of the fifth node N5, the third clock signal CK3 may be transmitted to a sixth node N6. A signal of the second node N2 may control on/off of the fifth transistor T5, and when the fifth transistor T5 is turned on in response to the signal of the second node N2, the third power signal may be transmitted to the sixth node N6.

The second electrode of the fourth transistor T4, the second electrode of the fifth transistor T5, and the first plate of the third capacitor C3 are all electrically connected to the sixth node N6.

As further shown in FIG. 6, for the second control sub-circuit 3, the sixth transistor T6 has a first electrode electrically connected to the fourth clock signal line CKL4, a second electrode electrically connected to a first electrode of the seventh transistor T7, and a control electrode electrically connected to the fourth node N4 and a first plate of the first capacitor C1; the seventh transistor T7 has the first electrode electrically connected to a second plate of the first capacitor C1, a second electrode electrically connected to the third node N3, and a control electrode electrically connected to the fourth clock signal line CKL4; and the eighth transistor T8 has a first electrode electrically connected to a fourth power signal line VGH2, a second electrode electrically connected to the third node N3, and a control electrode electrically connected to the first node N1. Specifically, a signal of the fourth node N4 may control on/off of the sixth transistor T6, and when the sixth transistor T6 is turned on in response to the signal of the fourth node N4, the fourth clock signal CK4 may be transmitted to a seventh node N7. The fourth clock signal CK4 may control on/off of the seventh transistor T7, and when the seventh transistor T7 is turned on in response to the fourth clock signal CK4, a signal of the seventh node N7 may be transmitted to the third node N3. A signal of the first node N1 may control on/off of the eighth transistor T8, and when the eighth transistor T8 is turned on in response to the signal of the first node N1, a fourth power signal may be transmitted to the third node N3.

The second electrode of the sixth transistor T6, the first electrode of the seventh transistor T7, and the second plate of the first capacitor C1 are all electrically connected to the seventh node N7.

As further shown in FIG. 6, for the output sub-circuit 4, the ninth transistor T9 has a first electrode electrically connected to a third power signal line VGH1 and a first plate of the second capacitor C2, a second electrode electrically connected to a signal output OUT, and a control electrode electrically connected to the third node N3; the tenth transistor T10 has a first electrode electrically connected to a second power signal line VGL2, a second electrode electrically connected to a signal output OUT, and a control electrode electrically connected to the fifth node N5; and the second capacitor C2 has a second plate electrically connected to the third node N3. Specifically, a signal of the third node N3 may control on/off of the ninth transistor T9, and when the ninth transistor T9 is turned on in response to the signal of the third node N3, a third power signal is transmitted to the signal output OUT, thereby outputting a second output signal. A signal of the fifth node N5 may control on/off of the tenth transistor T10, and when the tenth transistor T10 is turned on in response to the signal of the fifth node N5, a second power signal is output to the signal output OUT, thereby outputting a first output signal.

Illustratively, the third power signal has a potential lower than the fourth power signal, which can improve the off characteristics of the ninth transistor T9. For example, the third power signal has a potential of 7.5V, and the fourth power signal has a potential of 8V.

Illustratively, the first power signal has a potential lower than the second power signal, which can reduce the threshold loss of the tenth transistor T10 and ensure the output. For example, the first power signal has a potential of -8V, and the second power signal has a potential of -7.5V.

As further shown in FIG. 6, for the isolation sub-circuit 5, the eleventh transistor T11 has a first electrode electrically connected to the second node N2, a second electrode electrically connected to the fourth node N4, and a control electrode electrically connected to a first power signal line VGL1; and the twelfth transistor T12 has a first electrode electrically connected to the first node N1, a second electrode electrically connected to the fifth node N5, and a control electrode electrically connected to the first power signal line VGL1 (or second power signal line VGL2). Specifically, the first power signal may control on/off of the eleventh transistor T11 and the twelfth transistor T12, and when the eleventh transistor T11 is turned on in response to the first power signal, a signal of the second node N2 may be transmitted to the fourth node N4. When the twelfth transistor T12 is turned on in response to the first power signal, a signal of the first node N1 may be transmitted to the fifth node N5.

In this embodiment, four clock signal lines of different timings and four power signal lines of different potentials are adopted, so that the number of transistors coupled to a single clock signal line or a single power signal line is reduced, and the load on each clock signal line or each power signal line is reduced, thereby shortening the signal output time and promoting uniform image quality across a large-screen display. Meanwhile, since the clock signal lines have different timings, the influence on the display effect caused by simultaneous changes in timing is avoided. In addition, different power signal lines are adopted so that signal fluctuations caused by an excess load on a single power signal line can be avoided, thereby improving the stability of signal output.

In some embodiments, another 12T3C circuit structure is taken as an example for illustration, and the 12T3C circuit structure adopts the timing control of clock signal lines shown in FIG. 4. FIG. 7 is a circuit diagram of another 12T3C circuit structure according to an embodiment of the present disclosure. As shown in FIG. 7, the input sub-circuit 1 includes a first transistor T1, a second transistor T2, and a third transistor T3. The first control sub-circuit 2 includes a fourth transistor T4, a fifth transistor T5, and a third capacitor C3. The second control sub-circuit 3 includes a sixth transistor T6, a seventh transistor T7, an eighth transistor T8, and a first capacitor C1. The output sub-circuit 4 includes a ninth transistor T9, a tenth transistor T10, and a second capacitor C2. The isolation sub-circuit 5 includes an eleventh transistor T11 and a twelfth transistor T12.

As further shown in FIG. 7, for the input sub-circuit 1, the first transistor T1 has a first electrode electrically connected to a signal input Input, a second electrode electrically connected to the first node N1, and a control electrode electrically connected to the first clock signal line CKL1; the second transistor T2 has a first electrode electrically connected to the first clock signal line CKL1, a second electrode electrically connected to the second node N2, and a control electrode electrically connected to the first node N1; and the third transistor T3 has a first electrode electrically connected to a first power signal line VGL1, a second electrode electrically connected to the second node N2, and a control electrode electrically connected to the second clock signal line CKL2.

For the input sub-circuit 1 specifically, the first clock signal CK1 may control on/off of the first transistor T1, and when the first transistor T1 is turned on in response to the first clock signal CK1, an input signal may be transmitted to the first node N1. A signal of the first node N1 may control on/off of the second transistor T2, and when the second transistor T2 is turned on in response to the signal of the first node N1, the first clock signal CK1 may be transmitted to the second node N2. The second clock signal CK2 may control on/off of the third transistor T3, and when the third transistor T3 is turned on in response to the second clock signal CK2, a first power signal may be transmitted to the second node N2.

Illustratively, as shown in FIG. 4, the first level of the first clock signal CK1 has a different potential from the first level of the second clock signal CK2; and the second level of the first clock signal CK1 has a different potential from the second level of the second clock signal CK2.

As further shown in FIG. 7, for the first control sub-circuit 2, the fourth transistor T4 has a first electrode electrically connected to the third clock signal line CKL3, a second electrode electrically connected to a second electrode of the fifth transistor T5, and a control electrode electrically connected to the fifth node N5; the fifth transistor T5 has a first electrode electrically connected to a third power signal line VGH1, the second electrode electrically connected to a first plate of the third capacitor C3, and a control electrode electrically connected to the second node N2; and the third capacitor C3 has a second plate electrically connected to the fifth node N5.

For the first control sub-circuit 2 specifically, a signal of the fifth node N5 may control on/off of the fourth transistor T4, and when the fourth transistor T4 is turned on in response to the signal of the fifth node N5, the third clock signal CK3 may be transmitted to a sixth node N6. A signal of the second node N2 may control on/off of the fifth transistor T5, and when the fifth transistor T5 is turned on in response to the signal of the second node N2, the third power signal may be transmitted to the sixth node N6.

The second electrode of the fourth transistor T4, the second electrode of the fifth transistor T5, and the first plate of the third capacitor C3 are all electrically connected to the sixth node N6.

As further shown in FIG. 7, for the second control sub-circuit 3, the sixth transistor T6 has a first electrode electrically connected to the fourth clock signal line CKL4, a second electrode electrically connected to a first electrode of the seventh transistor T7, and a control electrode electrically connected to the fourth node N4 and a first plate of the first capacitor C1; the seventh transistor T7 has the first electrode electrically connected to a second plate of the first capacitor C1, a second electrode electrically connected to the third node N3, and a control electrode electrically connected to the fourth clock signal line CKL4; and the eighth transistor T8 has a first electrode electrically connected to a fourth power signal line VGH2, a second electrode electrically connected to the third node N3, and a control electrode electrically connected to the first node N1.

For the second control sub-circuit 3 specifically, a signal of the fourth node N4 may control on/off of the sixth transistor T6, and when the sixth transistor T6 is turned on in response to the signal of the fourth node N4, the fourth clock signal CK4 may be transmitted to a seventh node N7. The fourth clock signal CK4 may control on/off of the seventh transistor T7, and when the seventh transistor T7 is turned on in response to the fourth clock signal CK4, a signal of the seventh node N7 may be transmitted to the third node N3. A signal of the first node N1 may control on/off of the eighth transistor T8, and when the eighth transistor T8 is turned on in response to the signal of the first node N1, a fourth power signal may be transmitted to the third node N3.

The second electrode of the sixth transistor T6, the first electrode of the seventh transistor T7, and the second plate of the first capacitor C1 are all electrically connected to the seventh node N7.

As further shown in FIG. 7, for the output sub-circuit 4, the ninth transistor T9 has a first electrode electrically connected to a third power signal line VGH1 and a first plate of the second capacitor C2, a second electrode electrically connected to a signal output OUT, and a control electrode electrically connected to the third node N3; the tenth transistor T10 has a first electrode electrically connected to a second power signal line VGL2, a second electrode electrically connected to a signal output OUT, and a control electrode electrically connected to the fifth node N5; and the second capacitor C2 has a second plate electrically connected to the third node N3.

For the output sub-circuit 4, a signal of the third node N3 may control on/off of the ninth transistor T9, and when the ninth transistor T9 is turned on in response to the signal of the third node N3, a third power signal is transmitted to the signal output OUT, thereby outputting a second output signal. A signal of the fifth node N5 may control on/off of the tenth transistor T10, and when the tenth transistor T10 is turned on in response to the signal of the fifth node N5, a second power signal is output to the signal output OUT, thereby outputting a first output signal.

Illustratively, the third power signal has a potential lower than the fourth power signal, which can improve the off characteristics of the ninth transistor T9.

Illustratively, the first power signal has a potential lower than the second power signal, which can reduce the threshold loss of the tenth transistor T10 and ensure the output.

As further shown in FIG. 7, for the isolation sub-circuit 5, the eleventh transistor T11 has a first electrode electrically connected to the second node N2, a second electrode electrically connected to the fourth node N4, and a control electrode electrically connected to a first power signal line VGL1; and the twelfth transistor T12 has a first electrode electrically connected to the first node N1, a second electrode electrically connected to the fifth node N5, and a control electrode electrically connected to the second power signal line VGL2.

Illustratively, for the isolation sub-circuit 5, the first power signal may control on/off of the eleventh transistor T11, and when the eleventh transistor T11 is turned on in response to the first power signal, a signal of the second node N2 may be transmitted to the fourth node N4. The second power signal may control on/off of the twelfth transistor T12, and when the twelfth transistor T12 is turned on in response to the second power signal, a signal of the first node N1 may be transmitted to the fifth node N5.

In this embodiment, four clock signal lines of different potentials and four power signal lines of different potentials are adopted, so that the number of transistors coupled to a single clock signal line or a single power signal line is reduced, and the load on each clock signal line or each power signal line is reduced, thereby shortening the signal output time and promoting uniform image quality across a large-screen display. Meanwhile, the first power signal line VGL1, the second power signal line VGL2, the third power signal line VGH1, and the fourth power signal line VGH2 are all different from each other, so that signal fluctuations caused by an excess load on a single power signal line can be avoided, and the stability of signal output is improved.

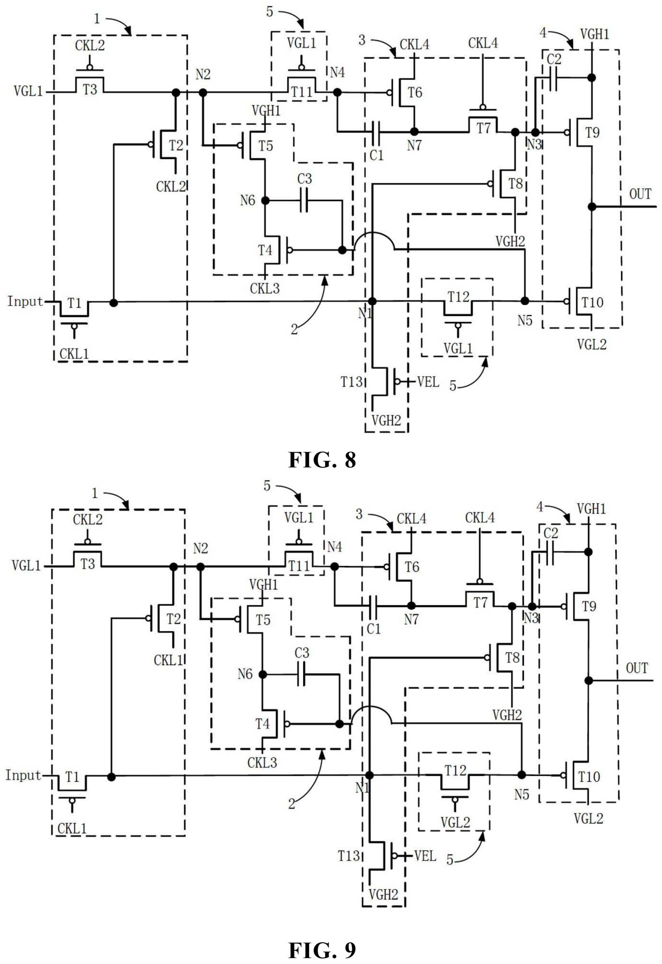

In some embodiments, a 13T3C circuit structure is taken as an example for illustration, and the 13T3C circuit structure adopts the timing control of clock signal lines shown in FIG. 2 or 3. FIG. 8 is a circuit diagram of a 13T3C circuit structure according to an embodiment of the present disclosure. As shown in FIG. 8, compared with the 12T3C circuit in FIG. 6, a thirteenth transistor T13 is added into the second control sub-circuit 3 in this embodiment to improve stability of the output signal and prevent defects like flicking in the display effect.

As shown in FIG. 8, the input sub-circuit 1 includes a first transistor T1, a second transistor T2, and a third transistor T3. The first control sub-circuit 2 includes a fourth transistor T4, a fifth transistor T5, and a third capacitor C3. The second control sub-circuit 3 includes a sixth transistor T6, a seventh transistor T7, an eighth transistor T8, a thirteenth transistor T13, and a first capacitor C1. The output sub-circuit 4 includes a ninth transistor T9, a tenth transistor T10, and a second capacitor C2. The isolation sub-circuit 5 includes an eleventh transistor T11 and a twelfth transistor T12.

The circuit structures, connection relationships, and working principles of the input sub-circuit 1, the first control sub-circuit 2, the output sub-circuit 4, and the isolation sub-circuit 5 here are the same as those of the input sub-circuit 1, the first control sub-circuit 2, the output sub-circuit 4, and the isolation sub-circuit 5 in the 12T3C circuit of FIG. 6, and details thereof may be found in the above description and thus are not repeated here.

As further shown in FIG. 8, for the second control sub-circuit 3, the sixth transistor T6 has a first electrode electrically connected to the fourth clock signal line CKL4, a second electrode electrically connected to a first electrode of the seventh transistor T7, and a control electrode electrically connected to the fourth node N4 and a first plate of the first capacitor C1; the seventh transistor T7 has the first electrode electrically connected to a second plate of the first capacitor C1, a second electrode electrically connected to the third node N3, and a control electrode electrically connected to the fourth clock signal line CKL4; the eighth transistor T8 has a first electrode electrically connected to a fourth power signal line VGH2, a second electrode electrically connected to the third node N3, and a control electrode electrically connected to the first node N1; and the thirteenth transistor T13 has a first electrode electrically connected to the fourth power signal line VGH2, a second electrode electrically connected to the first node N1, and a control electrode electrically connected to a preset control terminal VEL. Specifically, a signal of the fourth node N4 may control on/off of the sixth transistor T6, and when the sixth transistor T6 is turned on in response to the signal of the fourth node N4, the fourth clock signal CK4 may be transmitted to a seventh node N7. The fourth clock signal CK4 may control on/off of the seventh transistor T7, and when the seventh transistor T7 is turned on in response to the fourth clock signal CK4, a signal of the seventh node N7 may be transmitted to the third node N3. A signal of the first node N1 may control on/off of the eighth transistor T8, and when the eighth transistor T8 is turned on in response to the signal of the first node N1, a fourth power signal may be transmitted to the third node N3. A preset control signal may be coupled to a preset control terminal VEL to control on/off of the thirteenth transistor T13, and when the thirteenth transistor T13 is turned on in response to the preset control signal, a fourth power signal may be transmitted to the first node N1.

It should be noted that in an initialization phase prior to a working phase of the shift register, the preset control signal is a low-level signal, and the thirteenth transistor T13 is turned on; and in the formal working phase, the preset control signal remains a high-level signal, and the thirteenth transistor T13 is turned off.

In some embodiments, another 13T3C circuit structure is taken as an example for illustration, and the 13T3C circuit structure adopts the timing control of clock signal lines shown in FIG. 4. FIG. 9 is a circuit diagram of another 13T3C circuit structure according to an embodiment of the present disclosure. As shown in FIG. 9, compared with the 12T3C circuit in FIG. 7, a thirteenth transistor T13 is added into the second control sub-circuit 3 in this embodiment to improve stability of the output signal and prevent defects like flicking in the display effect.

As shown in FIG. 9, the input sub-circuit 1 includes a first transistor T1, a second transistor T2, and a third transistor T3. The first control sub-circuit 2 includes a fourth transistor T4, a fifth transistor T5, and a third capacitor C3. The second control sub-circuit 3 includes a sixth transistor T6, a seventh transistor T7, an eighth transistor T8, a thirteenth transistor T13, and a first capacitor C1. The output sub-circuit 4 includes a ninth transistor T9, a tenth transistor T10, and a second capacitor C2. The isolation sub-circuit 5 includes an eleventh transistor T11 and a twelfth transistor T12.

As further shown in FIG. 9, for the input sub-circuit 1, the first transistor T1 has a first electrode electrically connected to a signal input Input, a second electrode electrically connected to the first node N1, and a control electrode electrically connected to the first clock signal line CKL1; the second transistor T2 has a first electrode electrically connected to the first clock signal line CKL1, a second electrode electrically connected to the second node N2, and a control electrode electrically connected to the first node N1; and the third transistor T3 has a first electrode electrically connected to a first power signal line VGL1, a second electrode electrically connected to the second node N2, and a control electrode electrically connected to the second clock signal line CKL2.

For the input sub-circuit 1 specifically, the first clock signal CK1 may control on/off of the first transistor T1, and when the first transistor T1 is turned on in response to the first clock signal CK1, an input signal may be transmitted to the first node N1. A signal of the first node N1 may control on/off of the second transistor T2, and when the second transistor T2 is turned on in response to the signal of the first node N1, the first clock signal CK1 may be transmitted to the second node N2. The second clock signal CK2 may control on/off of the third transistor T3, and when the third transistor T3 is turned on in response to the second clock signal CK2, a first power signal may be transmitted to the second node N2.

Illustratively, the first level of the first clock signal CK1 has a different potential from the first level of the second clock signal CK2; and the second level of the first clock signal CK1 has a different potential from the second level of the second clock signal CK2.

As further shown in FIG. 9, for the first control sub-circuit 2, the fourth transistor T4 has a first electrode electrically connected to the third clock signal line CKL3, a second electrode electrically connected to a second electrode of the fifth transistor T5, and a control electrode electrically connected to the fifth node N5; the fifth transistor T5 has a first electrode electrically connected to a third power signal line VGH1, the second electrode electrically connected to a first plate of the third capacitor C3, and a control electrode electrically connected to the second node N2; and the third capacitor C3 has a second plate electrically connected to the fifth node N5.

For the first control sub-circuit 2 specifically, a signal of the fifth node N5 may control on/off of the fourth transistor T4, and when the fourth transistor T4 is turned on in response to the signal of the fifth node N5, the third clock signal CK3 may be transmitted to a sixth node N6. A signal of the second node N2 may control on/off of the fifth transistor T5, and when the fifth transistor T5 is turned on in response to the signal of the second node N2, the third power signal may be transmitted to the sixth node N6.

The second electrode of the fourth transistor T4, the second electrode of the fifth transistor T5, and the first plate of the third capacitor C3 are all electrically connected to the sixth node N6.

As further shown in FIG. 9, for the second control sub-circuit 3, the sixth transistor T6 has a first electrode electrically connected to the fourth clock signal line CKL4, a second electrode electrically connected to a first electrode of the seventh transistor T7, and a control electrode electrically connected to the fourth node N4 and a first plate of the first capacitor C1; the seventh transistor T7 has the first electrode electrically connected to a second plate of the first capacitor C1, a second electrode electrically connected to the third node N3, and a control electrode electrically connected to the fourth clock signal line CKL4; and the eighth transistor T8 has a first electrode electrically connected to a fourth power signal line VGH2, a second electrode electrically connected to the third node N3, and a control electrode electrically connected to the first node N1; and the thirteenth transistor T13 has a first electrode electrically connected to the fourth power signal line VGH2, a second electrode electrically connected to the first node N1, and a control electrode electrically connected to a preset control terminal VEL.

For the second control sub-circuit 3 specifically, a signal of the fourth node N4 may control on/off of the sixth transistor T6, and when the sixth transistor T6 is turned on in response to the signal of the fourth node N4, the fourth clock signal CK4 may be transmitted to a seventh node N7. The fourth clock signal CK4 may control on/off of the seventh transistor T7, and when the seventh transistor T7 is turned on in response to the fourth clock signal CK4, a signal of the seventh node N7 may be transmitted to the third node N3. A signal of the first node N1 may control on/off of the eighth transistor T8, and when the eighth transistor T8 is turned on in response to the signal of the first node N1, a fourth power signal may be transmitted to the third node N3.

A preset control signal may be coupled to control on/off of the thirteenth transistor T13, and when the thirteenth transistor T13 is turned on in response to the preset control signal, a fourth power signal may be transmitted to the first node N1.

It should be noted that in an initialization phase prior to a working phase of the shift register, the preset control signal is a low-level signal, and the thirteenth transistor T13 is turned on; and in the formal working phase, the preset control signal remains a high-level signal, and the thirteenth transistor T13 is turned off.

As further shown in FIG. 9, for the output sub-circuit 4, the ninth transistor T9 has a first electrode electrically connected to a third power signal line VGH1 and a first plate of the second capacitor C2, a second electrode electrically connected to a signal output OUT, and a control electrode electrically connected to the third node N3; the tenth transistor T10 has a first electrode electrically connected to a second power signal line VGL2, a second electrode electrically connected to a signal output OUT, and a control electrode electrically connected to the fifth node N5; the second capacitor C2 has a second plate electrically connected to the third node N3.

For the output sub-circuit 4, a signal of the third node N3 may control on/off of the ninth transistor T9, and when the ninth transistor T9 is turned on in response to the signal of the third node N3, a third power signal is transmitted to the signal output OUT, thereby outputting a second output signal. A signal of the fifth node N5 may control on/off of the tenth transistor T10, and when the tenth transistor T10 is turned on in response to the signal of the fifth node N5, a second power signal is output to the signal output OUT, thereby outputting a first output signal.

Illustratively, the third power signal has a potential lower than the fourth power signal, which can improve the off characteristics of the ninth transistor T9.

Illustratively, the first power signal has a potential lower than the second power signal, which can reduce the threshold loss of the tenth transistor T10 and ensure the output.

As further shown in FIG. 9, for the isolation sub-circuit 5, the eleventh transistor T11 has a first electrode electrically connected to the second node N2, a second electrode electrically connected to the fourth node N4, and a control electrode electrically connected to a first power signal line VGL1; and the twelfth transistor T12 has a first electrode electrically connected to the first node N1, a second electrode electrically connected to the fifth node N5, and a control electrode electrically connected to the second power signal line VGL2.

Illustratively, for the isolation sub-circuit 5, the first power signal may control on/off of the eleventh transistor T11, and when the eleventh transistor T11 is turned on in response to the first power signal, a signal of the second node N2 may be transmitted to the fourth node N4. The second power signal may control on/off of the twelfth transistor T12, and when the twelfth transistor T12 is turned on in response to the second power signal, a signal of the first node N1 may be transmitted to the fifth node N5.

In this embodiment, four clock signal lines of different potentials and four power signal lines of different potentials are adopted, so that the number of transistors coupled to a single clock signal line or a single power signal line is reduced, and the load on each clock signal line or each power signal line is reduced, thereby shortening the signal output time and promoting uniform image quality across a large-screen display. Meanwhile, the first power signal line VGL1, the second power signal line VGL2, the third power signal line VGH1, and the fourth power signal line VGH2 are all different from each other, so that signal fluctuations caused by an excess load on a single power signal line can be avoided, and the stability of signal output is improved. In addition, load balance is achieved on each power signal line. For example, the first power signal line VGL1 is coupled to the third transistor T3 and the eleventh transistor T11, and the second power signal line VGL2 is coupled to the tenth transistor T10 and the twelfth transistor T12. The third power signal line VGH1 is coupled to the ninth transistor T9 and the fifth transistor T5, and the fourth power signal line VGH2 is coupled to the eighth transistor T8 and the thirteenth transistor T13. Therefore, the display effect is further improved.

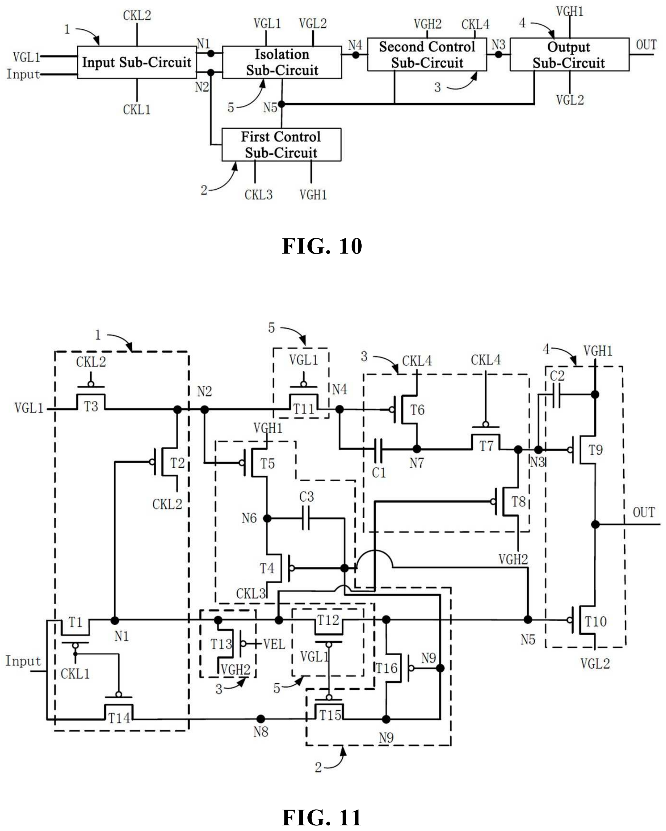

In some embodiments, FIG. 10 is a schematic structural diagram of another shift register according to an embodiment of the present disclosure. As shown in FIG. 10, the shift register further includes an isolation sub-circuit 5. The isolation sub-circuit 5 is configured to isolate the first node N1 from the first control sub-circuit 2 electrically connected to the first node N1; isolate the first node N1 from the output sub-circuit 4 electrically connected to the first node N1; isolate the first node N1 from the second control sub-circuit 3 electrically connected to the first node N1; and isolate the second node N2 from the second control sub-circuit 3 electrically connected to the second node N2.

As shown in FIG. 10, the first control sub-circuit 2 is electrically connected to a fifth node N5; the output sub-circuit 4 is electrically connected to the fifth node N5; and the second control sub-circuit 3 is electrically connected to a fourth node N4 and the fifth node N5.

As shown in FIG. 10, the isolation sub-circuit 5 is electrically connected to the first node N1, the second node N2, the fourth node N4, the fifth node N5, the first power signal line VGL1, and the second power signal line VGL2. The isolation sub-circuit 5 is configured to communicate the first node N1 and the fifth node N5 in response to a second power signal; and communicate the second node N2 and the fourth node N4 in response to a first power signal.

Alternatively, the isolation sub-circuit 5 is electrically connected to the first node N1, the second node N2, the fourth node N4, the fifth node N5, and the first power signal line VGL1. The isolation sub-circuit 5 is configured to communicate the first node N1 and the fifth node N5, and communicate the second node N2 and the fourth node N4, in response to the first power signal.

In this embodiment, the isolation sub-circuit 5 is provided to improve stable output of the output signal.

A 16T3C circuit structure is taken as an example for illustration, and the 16T3C circuit structure adopts the timing control of clock signal lines shown in FIG. 2 or 3. FIG. 11 is a circuit diagram of a 16T3C circuit structure according to an embodiment of the present disclosure. As shown in FIG. 11, compared with the 13T3C circuit in FIG. 8, a fourteenth transistor T14 is added into the input sub-circuit 1, and a fifteenth transistor T15 and a sixteenth transistor T16 are added into the first control sub-circuit 2 in this embodiment.

As shown in FIG. 11, the input sub-circuit 1 includes a first transistor T1, a second transistor T2, a third transistor T3, and a fourteenth transistor T14. The first control sub-circuit 2 includes a fourth transistor T4, a fifth transistor, a fifteenth transistor T5, a sixteenth transistor T15, T16 and a third capacitor C3. The second control sub-circuit 3 includes a sixth transistor T6, a seventh transistor T7, an eighth transistor T8, a thirteenth transistor T13, and a first capacitor C1. The output sub-circuit 4 includes a ninth transistor T9, a tenth transistor T10, and a second capacitor C2. The isolation sub-circuit 5 includes an eleventh transistor T11 and a twelfth transistor T12.

The circuit structures, connection relationships, and working principles of the second control sub-circuit 3, the output sub-circuit 4, and the isolation sub-circuit 5 here are the same as those of the second control sub-circuit 3, the output sub-circuit 4, and the isolation sub-circuit 5 in the circuit 13T3C of FIG. 8, and details thereof may be found in the above description and thus are not repeated here.

As further shown in FIG. 11, for the input sub-circuit 1, the first transistor T1 has a first electrode electrically connected to a signal input Input, a second electrode electrically connected to the first node N1, and a control electrode electrically connected to the first clock signal line CKL1; the second transistor T2 has a first electrode electrically connected to the second clock signal line CKL2, a second electrode electrically connected to the second node N2, and a control electrode electrically connected to the first node N1; the third transistor T3 has a first electrode electrically connected to a first power signal line VGL1, a second electrode electrically connected to the second node N2, and a control electrode electrically connected to the second clock signal line CKL2; and the fourteenth transistor T14 has a first electrode electrically connected to a signal input Input, a second electrode electrically connected to an eighth node N8, and a control electrode electrically connected to the first clock signal line CKL1. Specifically, the first clock signal CK1 may control on/off of the first transistor T1, and when the first transistor T1 is turned on in response to the first clock signal CK1, an input signal may be transmitted to the first node N1. A signal of the first node N1 may control on/off of the second transistor T2, and when the second transistor T2 is turned on in response to the signal of the first node N1, the second clock signal CK2 may be transmitted to the second node N2. The second clock signal CK2 may control on/off of the third transistor T3, and when the third transistor T3 is turned on in response to the second clock signal CK2, a first power signal may be transmitted to the second node N2. the first clock signal CK1 may further control on/off of the fourteenth transistor T14, and when the fourteenth transistor T14 is turned on in response to the first clock signal CK1, an input signal may be transmitted to the eighth node N8.

As further shown in FIG. 11, for the first control sub-circuit 2, the fourth transistor T4 has a first electrode electrically connected to the third clock signal line CKL3, a second electrode electrically connected to a second electrode of the fifth transistor T5, and a control electrode electrically connected to a second plate of the third capacitor C3; the fifth transistor T5 has a first electrode electrically connected to a third power signal line VGH1, the second electrode electrically connected to a first plate of the third capacitor C3, and a control electrode electrically connected to the second node N2; the fifteenth transistor T15 has a first electrode electrically connected to the eighth node N8, a second electrode electrically connected a first electrode and a control electrode of the sixteenth transistor T16, and a control electrode electrically connected to a first power signal line VGL1; and the sixteenth transistor T16 has a second electrode electrically connected to the fifth node N5, and the control electrode electrically connected to the control electrode of the fourth transistor T4. Specifically, a signal of the fifth node N5 may control on/off of the fourth transistor T4, and when the fourth transistor T4 is turned on in response to the signal of the fifth node N5, the third clock signal CK3 may be transmitted to a sixth node N6. A signal of the second node N2 may control on/off of the fifth transistor T5, and when the fifth transistor T5 is turned on in response to the signal of the second node N2, the third power signal may be transmitted to the sixth node N6. The first power signal may control on/off of the fifteenth transistor T15, and when the fifteenth transistor T15 is turned on in response to the first power signal, a signal of the eighth node N8 may be transmitted to a ninth node N9. a signal of the ninth node N9 may control on/off of the sixteenth transistor T16, and when the sixteenth transistor T16 is turned on in response to the signal of the ninth node N9, a signal of the ninth node N9 may be transmitted to the fifth node N5.

In this embodiment, four clock signal lines of different timings and four power signal lines of different potentials are adopted, so that the number of transistors coupled to a single clock signal line or a single power signal line is reduced, and the load on each clock signal line or each power signal line is reduced, thereby shortening the signal output time and promoting uniform image quality across a large-screen display. Meanwhile, since the clock signal lines have different timings, the influence on the display effect caused by simultaneous changes in timing is avoided. In addition, different power signal lines are adopted so that signal fluctuations caused by an excess load on a single power signal line can be avoided, thereby improving the stability of signal output. In addition, load balance is achieved on each power signal line. For example, the third power signal line VGH1 is coupled to the ninth transistor T9 and the fifth transistor T5, and the fourth power signal line VGH2 is coupled to the eighth transistor T8 and the thirteenth transistor T13. Therefore, the display effect is further improved.

Optionally, for the first control sub-circuit 2, the fifth transistor T5 may have a first electrode is electrically connected to the fourth power signal line VGH2.

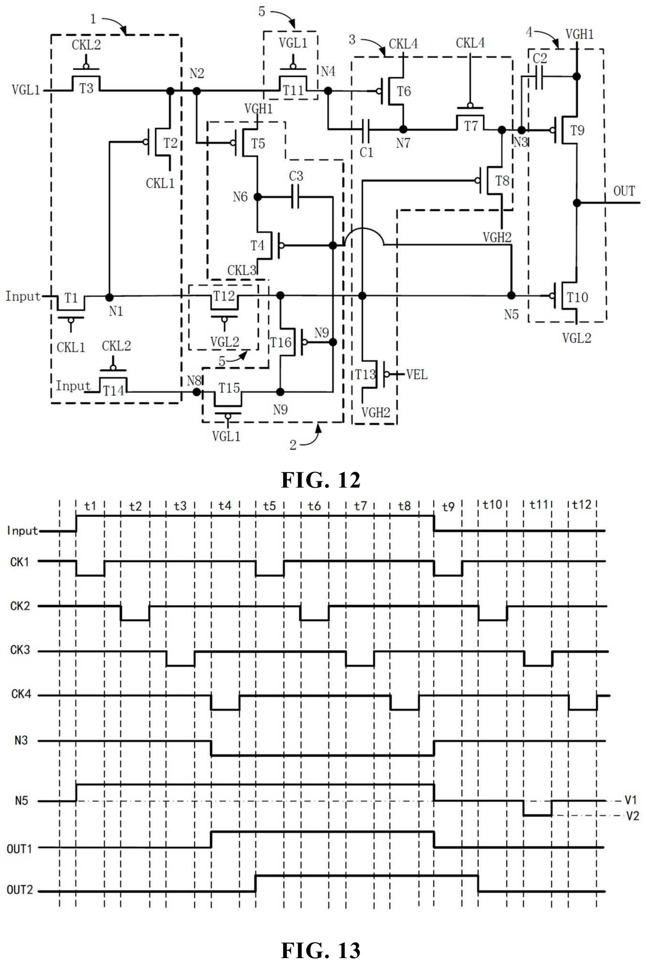

In some embodiments, another 16T3C circuit structure is taken as an example for illustration, and the 16T3C circuit structure adopts the timing control of clock signal lines shown in FIG. 4. FIG. 12 is a circuit diagram of another 16T3C circuit structure according to an embodiment of the present disclosure. As shown in FIG. 12, compared with the 13T3C circuit in FIG. 9, a fourteenth transistor T14 is added into the input sub-circuit 1, and a fifteenth transistor T15 and a sixteenth transistor T16 are added into the first control sub-circuit 2 in this embodiment.

As shown in FIG. 12, the input sub-circuit 1 includes a first transistor T1, a second transistor T2, a third transistor T3, and a fourteenth transistor T14. The first control sub-circuit 2 includes a fourth transistor T4, a fifth transistor, a fifteenth transistor T5, a sixteenth transistor T15, T16 and a third capacitor C3. The second control sub-circuit 3 includes a sixth transistor T6, a seventh transistor T7, an eighth transistor T8, a thirteenth transistor T13, and a first capacitor C1. The output sub-circuit 4 includes a ninth transistor T9, a tenth transistor T10, and a second capacitor C2. The isolation sub-circuit 5 includes an eleventh transistor T11 and a twelfth transistor T12.

As further shown in FIG. 12, for the input sub-circuit 1, the first transistor T1 has a first electrode electrically connected to a signal input Input, a second electrode electrically connected to the first node N1, and a control electrode electrically connected to the first clock signal line CKL1; the second transistor T2 has a first electrode electrically connected to the first clock signal line CKL1, a second electrode electrically connected to the second node N2, and a control electrode electrically connected to the first node N1; the third transistor T3 has a first electrode electrically connected to a first power signal line VGL1, a second electrode electrically connected to the second node N2, and a control electrode electrically connected to the second clock signal line CKL2; and the fourteenth transistor T14 has a first electrode electrically connected to a signal input Input, a second electrode electrically connected to an eighth node N8, and a control electrode electrically connected to the second clock signal line CKL2.

For the input sub-circuit 1 specifically, the first clock signal CK1 may control on/off of the first transistor T1, and when the first transistor T1 is turned on in response to the first clock signal CK1, an input signal may be transmitted to the first node N1. A signal of the first node N1 may control on/off of the second transistor T2, and when the second transistor T2 is turned on in response to the signal of the first node N1, the first clock signal CK1 may be transmitted to the second node N2. The second clock signal CK2 may control on/off of the third transistor T3, and when the third transistor T3 is turned on in response to the second clock signal CK2, a first power signal may be transmitted to the second node N2. The second clock signal CK2 may further control on/off of the fourteenth transistor T14, and when the fourteenth transistor T14 is turned on in response to the second clock signal CK2, an input signal may be transmitted to the eighth node N8.

Illustratively, as shown in FIG. 4, the first level of the first clock signal CK1 has a different potential from the first level of the second clock signal CK2; and the second level of the first clock signal CK1 has a different potential from the second level of the second clock signal CK2, so that defects such as a transistor hysteresis failure, which may affect the characteristics of the transistors and be caused by gates and sources of the third transistor T3 and the first transistor T1 at the same voltage difference for a long time and gates and sources of the fourteenth transistor T14 and the first transistor T1 at the same voltage difference for a long time, can be avoided.

As further shown in FIG. 12, for the first control sub-circuit 2, the fourth transistor T4 has a first electrode electrically connected to the third clock signal line CKL3, a second electrode electrically connected to a second electrode of the fifth transistor T5, and a control electrode electrically connected to a second plate of the third capacitor C3; the fifth transistor T5 has a first electrode electrically connected to a third power signal line VGH1, the second electrode electrically connected to a first plate of the third capacitor C3, and a control electrode electrically connected to the second node N2; the fifteenth transistor T15 has a first electrode electrically connected to the eighth node N8, a second electrode electrically connected a first electrode and a control electrode of the sixteenth transistor T16, and a control electrode electrically connected to a first power signal line VGL1; and the sixteenth transistor T16 has a second electrode electrically connected to the fifth node N5, and the control electrode electrically connected to the control electrode of the fourth transistor T4.

For the first control sub-circuit 2 specifically, a signal of the fifth node N5 may control on/off of the fourth transistor T4, and when the fourth transistor T4 is turned on in response to the signal of the fifth node N5, the third clock signal CK3 may be transmitted to a sixth node N6. A signal of the second node N2 may control on/off of the fifth transistor T5, and when the fifth transistor T5 is turned on in response to the signal of the second node N2, the third power signal may be transmitted to the sixth node N6. The first power signal may control on/off of the fifteenth transistor T15, and when the fifteenth transistor T15 is turned on in response to the first power signal, a signal of the eighth node N8 may be transmitted to a ninth node N9. A signal of the ninth node N9 may control on/off of the sixteenth transistor T16, and when the sixteenth transistor T16 is turned on in response to the signal of the ninth node N9, a signal of the ninth node N9 may be transmitted to the fifth node N5.

The control electrode of the fourth transistor T4, the second plate of the third capacitor C3, the second electrode of the fifteenth transistor T15, the second electrode of the sixteenth transistor T16, and the control electrode of the sixteenth transistor T16 are all electrically connected to the ninth node N9.

As further shown in FIG. 12, for the second control sub-circuit 3, the sixth transistor T6 has a first electrode electrically connected to the fourth clock signal line CKL4, a second electrode electrically connected to a first electrode of the seventh transistor T7, and a control electrode electrically connected to the fourth node N4 and a first plate of the first capacitor C1; the seventh transistor T7 has the first electrode electrically connected to a second plate of the first capacitor C1, a second electrode electrically connected to the third node N3, and a control electrode electrically connected to the fourth clock signal line CKL4; the eighth transistor T8 has a first electrode electrically connected to a fourth power signal line VGH2, a second electrode electrically connected to the third node N3, and a control electrode electrically connected to the fifth node N5; and the thirteenth transistor T13 has a first electrode electrically connected to a fourth power signal line VGH2, a second electrode electrically connected to the fifth node N5, and a control electrode electrically connected to a preset control terminal VEL.

For the second control sub-circuit 3 specifically, a signal of the fourth node N4 may control on/off of the sixth transistor T6, and when the sixth transistor T6 is turned on in response to the signal of the fourth node N4, the fourth clock signal CK4 may be transmitted to a seventh node N7. The fourth clock signal CK4 may control on/off of the seventh transistor T7, and when the seventh transistor T7 is turned on in response to the fourth clock signal CK4, a signal of the seventh node N7 may be transmitted to the third node N3. A signal of the fifth node N5 may control on/off of the eighth transistor T8, and when the eighth transistor T8 is turned on in response to the signal of the fifth node N5, a fourth power signal may be transmitted to the third node N3.

A preset control signal may be coupled to control on/off of the thirteenth transistor T13, and when the thirteenth transistor T13 is turned on in response to the preset control signal, a fourth power signal may be transmitted to the fifth node N5.

As further shown in FIG. 12, for the output sub-circuit 4, the ninth transistor T9 has a first electrode electrically connected to a third power signal line VGH1 and a first plate of the second capacitor C2, a second electrode electrically connected to a signal output OUT, and a control electrode electrically connected to the third node N3; the tenth transistor T10 has a first electrode electrically connected to a second power signal line VGL2, a second electrode electrically connected to a signal output OUT, and a control electrode electrically connected to the fifth node N5; and the second capacitor C2 has a second plate electrically connected to the third node N3.

For the output sub-circuit 4, a signal of the third node N3 may control on/off of the ninth transistor T9, and when the ninth transistor T9 is turned on in response to the signal of the third node N3, a third power signal is transmitted to the signal output OUT, thereby outputting a second output signal. A signal of the fifth node N5 may control on/off of the tenth transistor T10, and when the tenth transistor T10 is turned on in response to the signal of the fifth node N5, a second power signal is output to the signal output OUT, thereby outputting a first output signal.

Illustratively, the third power signal has a potential lower than the fourth power signal, which can improve the off characteristics of the ninth transistor T9.

Illustratively, the first power signal has a potential lower than the second power signal, which can reduce the threshold loss of the tenth transistor T10 and ensure the output.

As further shown in FIG. 12, for the isolation sub-circuit 5, the eleventh transistor T11 has a first electrode electrically connected to the second node N2, a second electrode electrically connected to the fourth node N4, and a control electrode electrically connected to a first power signal line VGL1; and the twelfth transistor T12 has a first electrode electrically connected to the first node N1, a second electrode electrically connected to the fifth node N5, and a control electrode electrically connected to the second power signal line VGL2.

Illustratively, for the isolation sub-circuit 5, the first power signal may control on/off of the eleventh transistor T11, and when the eleventh transistor T11 is turned on in response to the first power signal, a signal of the second node N2 may be transmitted to the fourth node N4. The second power signal may control on/off of the twelfth transistor T12, and when the twelfth transistor T12 is turned on in response to the second power signal, a signal of the first node N1 may be transmitted to the fifth node N5.

In this embodiment, four clock signal lines of different potentials and four power signal lines of different potentials are adopted, so that the number of transistors coupled to a single clock signal line or a single power signal line is reduced, and the load on each clock signal line or each power signal line is reduced, thereby shortening the signal output time and promoting uniform image quality across a large-screen display. Meanwhile, the first power signal line VGL1, the second power signal line VGL2, the third power signal line VGH1, and the fourth power signal line VGH2 are all different from each other, so that signal fluctuations caused by an excess load on a single power signal line can be avoided, and the stability of signal output is improved. In addition, load balance is achieved on each power signal line. For example, the third power signal line VGH1 is coupled to the ninth transistor T9 and the fifth transistor T5, and the fourth power signal line VGH2 is coupled to the eighth transistor T8 and the thirteenth transistor T13. Therefore, the display effect is further improved.

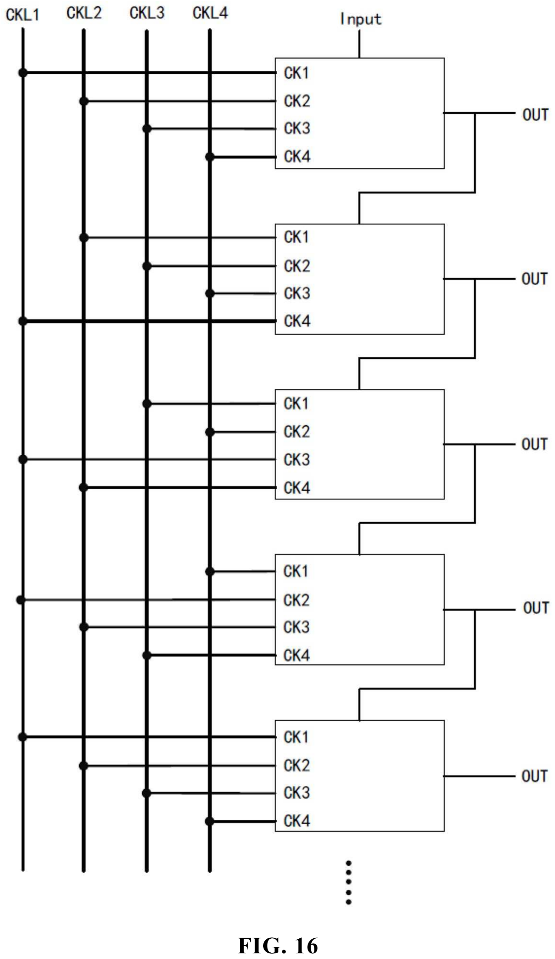

In some embodiments, the first transistor T1 and the third transistor T3 in the input sub-circuit 1 in each of the circuit structures of 12T3C in FIG. 7, 13T3C in FIG. 9, and 16T3C in FIG. 12 may be coupled to the same first clock signal line CKL1, while the second transistor T2 is coupled to the second clock signal line CKL2.

Illustratively, the input sub-circuit 1 includes a first transistor T1, a second transistor T2, and a third transistor T3. The first transistor T1 has a first electrode electrically connected to a signal input Input, a second electrode electrically connected to the first node N1, and a control electrode electrically connected to the first clock signal line CKL1. The second transistor T2 has a first electrode electrically connected to the second clock signal line CKL2, a second electrode electrically connected to the second node N2, and a control electrode electrically connected to the first node N1. The third transistor T3 has a first electrode electrically connected to a first power signal line VGL1, a second electrode electrically connected to the second node N2, and a control electrode electrically connected to the first clock signal line CKL1.

In some embodiments, the eleventh transistor T11 and the twelfth transistor T12 in the isolation sub-circuit 5 in each of the circuit structures of 12T3C in FIG. 7, 13T3C in FIG. 9, and 16T3C in FIG. 12 may also be coupled to the same first power signal line VGL1 to ensure stability of the output signal during isolation.

The working principle of the shift register provided in the embodiments of the present disclosure is described in further detail below.

In some embodiments, FIG. 13 is a timing diagram of an exemplary shift register according to an embodiment of the present disclosure. As shown in FIG. 13, a 12T3C circuit structure (i.e., the 12T3C circuit structure shown in FIG. 6) adopting the timing control of clock signal lines shown in FIG. 2 is taken as an example for illustration, where a working phase of the structure specifically includes a first phase t1, a second phase t2, a third phase t3, a fourth phase t4, a fifth phase t5, a sixth phase t6, a seventh phase t7, an eighth phase t8, a ninth phase t9, a tenth phase t10, an eleventh phase t11, and a twelfth phase t12.

In the first phase t1, the signal input Input transmits a high-level signal as the input signal, and the first clock signal CK1 is at an active level, which may be considered as a low level, while the second clock signal CK2, the third clock signal CK3 and the fourth clock signal CK4 are at an inactive level, which may be considered as a high level. The eleventh transistor T11 and the twelfth transistor T12 are always on. In this case, the first transistor T1 is turned on, a high level signal is written to the first node N1 and the fifth node N5, the second transistor T2, the fourth transistor T4, the eighth transistor T8, and the tenth transistor T10 are all turned off, the third node N3 maintains a high potential of a previous phase, and the ninth transistor T9 is turned off. At this time, the output signal remains the same as in the previous phase, and the signal output OUT outputs a first output signal with a low potential.

In the second phase t2, the signal input Input transmits a high-level signal as the input signal, and the second clock signal CK2 is at an active level, which may be considered as a low level, while the first clock signal CK1, the third clock signal CK3 and the fourth clock signal CK4 are at an inactive level, which may be considered as a high level. The eleventh transistor T11 and the twelfth transistor T12 are always on. In this case, the third transistor T3 is turned on, a low-level signal is written to the second node N2, the fifth transistor T5 is turned on, a high-level signal is written to the sixth node N6, the sixth transistor T6 is turned on, and a high-level signal is written to the seventh node N7. The first node N1 and the fifth node N5 maintain high potentials of the previous phase, the second transistor T2, the fourth transistor T4, the eighth transistor T8, and the tenth transistor T10 are all turned off, the seventh transistor T7 is also turned off, the third node N3 maintains a high potential of the previous phase, and the ninth transistor T9 is turned off. At this time, the output signal remains the same as in the previous phase, and the signal output OUT outputs a first output signal with a low potential.

In the third phase t3, the signal input Input transmits a high-level signal as the input signal, and the third clock signal CK3 is at an active level, which may be considered as a low level, while the first clock signal CK1, the second clock signal CK2 and the fourth clock signal CK4 are at an inactive level, which may be considered as a high level. The eleventh transistor T11 and the twelfth transistor T12 are always on. In this case, the first node N1 and the fifth node N5 maintain high potentials of the previous phase, while the second transistor T2, the fourth transistor T4, the eighth transistor T8, and the tenth transistor T10 are all turned off. The second node N2 and the fourth node N4 maintain low potentials of the previous phase, the sixth transistor T6 is turned on, and a high-level signal is written to the seventh node N7. However, the seventh transistor T7 remains off, so that the third node N3 maintains the high potential of the previous phase, and the ninth transistor T9 is turned off. At this time, the output signal remains the same as in the previous phase, and the signal output OUT outputs a first output signal with a low potential.

In the fourth phase t4, the signal input Input transmits a high-level signal as the input signal, and the fourth clock signal CK4 is at an active level, which may be considered as a low level, while the first clock signal CK1, the second clock signal CK2 and the third clock signal CK3 are at an inactive level, which may be considered as a high level. The eleventh transistor T11 and the twelfth transistor T12 are always on. In this case, the first node N1 and the fifth node N5 maintain high potentials of the previous phase, while the second transistor T2, the eighth transistor T8, and the tenth transistor T10 are all turned off. The second node N2 maintains a low potential of the previous phase, the fifth transistor T5 is turned on, a high-level signal is written to the sixth node N6. The fourth node N4 maintains a low potential of the previous phase, the sixth transistor T6 is turned on, and a low-level signal is written to the seventh node N7, while the seventh transistor T7 is turned on, a low-level signal is written to the third node N3, and the ninth transistor T9 is turned on. At this time, the signal output OUT outputs a second output signal with a high potential.

In the fifth phase t5, the signal input Input transmits a high-level signal as the input signal, and the first clock signal CK1 is at an active level, which may be considered as a low level, while the second clock signal CK2, the third clock signal CK3 and the fourth clock signal CK4 are at an inactive level, which may be considered as a high level. The eleventh transistor T11 and the twelfth transistor T12 are always on. In this case, the first transistor T1 is turned on, a high level signal is written to the first node N1 and the fifth node N5, the second transistor T2, the fourth transistor T4, the eighth transistor T8, and the tenth transistor T10 are all turned off, the third node N3 maintains a low potential of a previous phase, and the ninth transistor T9 is turned on. At this time, the signal output OUT outputs a second output signal with a high potential.

In the sixth phase t6, the signal input Input transmits a high-level signal as the input signal, and the second clock signal CK2 is at an active level, which may be considered as a low level, while the first clock signal CK1, the third clock signal CK3 and the fourth clock signal CK4 are at an inactive level, which may be considered as a high level. The eleventh transistor T11 and the twelfth transistor T12 are always on. In this case, the third transistor T3 is turned on, a low-level signal is written to the second node N2, the fifth transistor T5 is turned on, a high-level signal is written to the sixth node N6, the sixth transistor T6 is turned on, and a high-level signal is written to the seventh node N7. The first node N1 and the fifth node N5 maintain high potentials of the previous phase, the second transistor T2, the fourth transistor T4, the eighth transistor T8, and the tenth transistor T10 are all turned off, the seventh transistor T7 is also turned off, the third node N3 maintains a low potential of a previous phase, and the ninth transistor T9 is turned on. At this time, the signal output OUT outputs a second output signal with a high potential.

In the seventh phase t7, the signal input Input transmits a high-level signal as the input signal, and the third clock signal CK3 is at an active level, which may be considered as a low level, while the first clock signal CK1, the second clock signal CK2 and the fourth clock signal CK4 are at an inactive level, which may be considered as a high level. The eleventh transistor T11 and the twelfth transistor T12 are always on. In this case, the first node N1 and the fifth node N5 maintain high potentials of the previous phase, while the second transistor T2, the fourth transistor T4, the eighth transistor T8, and the tenth transistor T10 are all turned off. The second node N2 and the fourth node N4 maintain low potentials of the previous phase, the sixth transistor T6 is turned on, and a high-level signal is written to the seventh node N7. However, the seventh transistor T7 remains off, so that the third node N3 maintains a low potential of a previous phase, and the ninth transistor T9 is turned on. At this time, the signal output OUT outputs a second output signal with a high potential.

The eighth phase t8 has the same working state as the fourth phase t4. Specifically, in the eighth phase t8, the signal input Input transmits a high-level signal as the input signal, and the fourth clock signal CK4 is at an active level, which may be considered as a low level, while the first clock signal CK1, the second clock signal CK2 and the third clock signal CK3 are at an inactive level, which may be considered as a high level. The eleventh transistor T11 and the twelfth transistor T12 are always on. In this case, the first node N1 and the fifth node N5 maintain high potentials of the previous phase, while the second transistor T2, the fourth transistor T4, the eighth transistor T8, and the tenth transistor T10 are all turned off. The second node N2 maintains a low potential of the previous phase, the fifth transistor T5 is turned on, a high-level signal is written to the sixth node N6. The fourth node N4 maintains a low potential of the previous phase, the sixth transistor T6 is turned on, and a low-level signal is written to the seventh node N7, while the seventh transistor T7 is turned on, a low-level signal is written to the third node N3, and the ninth transistor T9 is turned on. At this time, the signal output OUT outputs a second output signal with a high potential.

In the ninth phase t9, the signal input Input transmits a low-level signal as the input signal, and the first clock signal CK1 is at an active level, which may be considered as a low level, while the second clock signal CK2, the third clock signal CK3 and the fourth clock signal CK4 are at an inactive level, which may be considered as a high level. The eleventh transistor T11 and the twelfth transistor T12 are always on. In this case, the first transistor T1 is turned on, a low-level signal is written to the first node N1, the second transistor T2 is turned on, a high-level signal is written to the second node N2, and the fifth transistor T5 and the sixth transistor T6 are turned off. Meanwhile, the fourth transistor T4 is turned on, and a high-level signal is written to the sixth node N6. Meanwhile, the eighth transistor T8 is turned on, a high-level signal is written to the third node N3, and the ninth transistor T9 is turned off. The fifth node N5 is communicated with the first node N1, and has a low potential V1 at this time, the tenth transistor T10 is turned on, and the signal output OUT outputs a first output signal with a low potential.

In the tenth phase t10, the signal input Input transmits a low-level signal as the input signal, and the second clock signal CK2 is at an active level, which may be considered as a low level, while the first clock signal CK1, the third clock signal CK3 and the fourth clock signal CK4 are at an inactive level, which may be considered as a high level. The eleventh transistor T11 and the twelfth transistor T12 are always on. In this case, the first node N1 and the fifth node N5 maintain the low potential V1 of the previous phase, the eighth transistor T8 remains on, a high-level signal is continuously written to the third node N3, the ninth transistor T9 remains off, the tenth transistor T10 remains on, and the signal output OUT continuously outputs a first output signal with a low potential.

In the eleventh phase t11, the signal input Input transmits a low-level signal as the input signal, and the third clock signal CK3 is at an active level, which may be considered as a low level, while the first clock signal CK1, the second clock signal CK2 and the fourth clock signal CK4 are at an inactive level, which may be considered as a high level. The eleventh transistor T11 and the twelfth transistor T12 are always on. In this case, the first node N1 maintains the low potential V1 of the previous phase, the second transistor T2 is turned on, a high-level signal is written to the second node N2, and the fifth transistor T5 and the sixth transistor T6 are turned off. Meanwhile, the eighth transistor T8 is turned on, a high-level signal is written to the third node N3, and the ninth transistor T9 is turned off. Meanwhile, the fourth transistor T4 is turned on, a low-level signal is written to the sixth node N6, the low potential V1 of the fifth node N5 is further pulled down to a low potential V2 by means of a third capacitor C3, the tenth transistor T10 remains on, and the signal output OUT outputs a first output signal with a low potential.

In the twelfth phase t12, the signal input Input transmits a high-level signal as the input signal, and the fourth clock signal CK4 is at an active level, which may be considered as a low level, while the first clock signal CK1, the second clock signal CK2 and the third clock signal CK3 are at an inactive level, which may be considered as a high level. The eleventh transistor T11 and the twelfth transistor T12 are always on. In this case, the first node N1 maintains the low potential V1 of the previous phase, the second transistor T2 is turned on, a high-level signal is written to the second node N2, and the fifth transistor T5 and the sixth transistor T6 are turned off. Meanwhile, the fourth transistor T4 is turned on, and a high-level signal is written to the sixth node N6. Meanwhile, the eighth transistor T8 is turned on, a high-level signal is written to the third node N3, and the ninth transistor T9 is turned off. The fifth node N5 is communicated with the first node N1, and has a low potential V1 at this time, the tenth transistor T10 is turned on, and the signal output OUT outputs a first output signal with a low potential (i.e., OUT1 in FIG. 13). The OUT2 in FIG. 13 indicates a signal output from the signal output OUT of a next stage cascaded shift register.

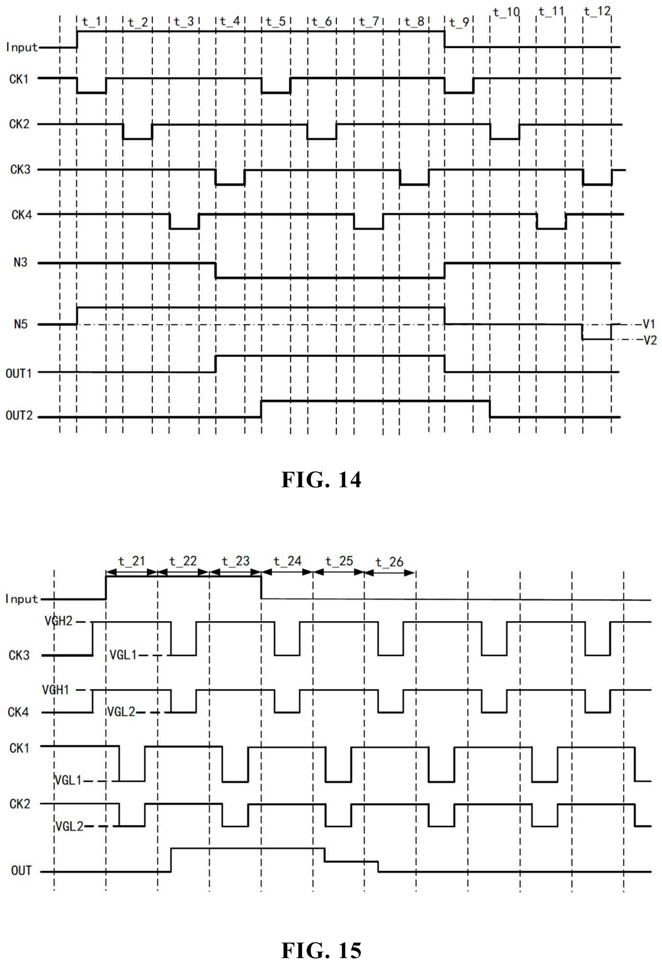

In some embodiments, FIG. 14 is a timing diagram of another exemplary shift register according to an embodiment of the present disclosure. As shown in FIG. 14, a 12T3C circuit structure (i.e., the 12T3C circuit structure shown in FIG. 6) adopting the timing control of clock signal lines shown in FIG. 3 is taken as an example for illustration, where a working phase of the structure specifically includes a first phase t_1, a second phase t_2, a third phase t_3, a fourth phase t_4, a fifth phase t_5, a sixth phase t_6, a seventh phase t_7, an eighth phase t_8, a ninth phase t_9, a tenth phase t_10, an eleventh phase t_11, and a twelfth phase t_12.

This timing differs from the timing in FIG. 13 in that: in the third phase t_3, the seventh phase t_7 and the eleventh phase t_11, the fourth clock signal CK4 is at an active level, while the first clock signal CK1, the second clock signal CK2 and the third clock signal CK3 are at an inactive level; and in the fourth phase t_4, the eighth phase t_8 and the twelfth phase t_12, the third clock signal CK3 is at an active level, while the first clock signal CK1, the second clock signal CK2 and the fourth clock signal CK4 are at an inactive level.

The first phases t_1 and t1, the second phases t_2 and t2, the fifth phases t_5 and t5, the sixth phases t_6 and t6, the ninth phases t_9 and t9, and the tenth phases t_10 and t10 are based on the same working principle, respectively, and repeated descriptions are omitted.

As shown in FIG. 14, in the eleventh phase t_11, the signal input Input transmits a high-level signal as the input signal, and the fourth clock signal CK4 is at an active level, which may be considered as a low level, while the first clock signal CK1, the second clock signal CK2 and the third clock signal CK3 are at an inactive level, which may be considered as a high level. The eleventh transistor T11 and the twelfth transistor T12 are always on. In this case, the first node N1 maintains a low potential V1 of a previous phase, the second transistor T2 is turned on, a high-level signal is written to the second node N2, and the fifth transistor T5 and the sixth transistor T6 are turned off. Meanwhile, the fourth transistor T4 is turned on, and a high-level signal is written to the sixth node N6. Meanwhile, the eighth transistor T8 is turned on, a high-level signal is written to the third node N3, and the ninth transistor T9 is turned off. The fifth node N5 is communicated with the first node N1, and has a low potential V1 at this time, the tenth transistor T10 is turned on, and the signal output OUT outputs a first output signal with a low potential.

As shown in FIG. 14, in the twelfth phase t_12, the signal input Input transmits a low-level signal as the input signal, and the third clock signal CK3 is at an active level, which may be considered as a low level, while the first clock signal CK1, the second clock signal CK2 and the fourth clock signal CK4 are at an inactive level, which may be considered as a high level. The eleventh transistor T11 and the twelfth transistor T12 are always on. In this case, the first node N1 maintains the low potential V1 of the previous phase, the second transistor T2 is turned on, a high-level signal is written to the second node N2, and the fifth transistor T5 and the sixth transistor T6 are turned off. Meanwhile, the eighth transistor T8 is turned on, a high-level signal is written to the third node N3, and the ninth transistor T9 is turned off. Meanwhile, the fourth transistor T4 is turned on, a low-level signal is written to the sixth node N6, the low potential V1 of the fifth node N5 is further pulled down to a low potential V2 by means of a third capacitor C3, the tenth transistor T10 remains on, and the signal output OUT outputs a first output signal with a low potential.

In some embodiments, FIG. 15 is a timing diagram of another exemplary shift register according to an embodiment of the present disclosure. As shown in FIG. 15, a 12T3C circuit structure (i.e., the 12T3C circuit structure shown in FIG. 7) adopting the timing control of clock signal lines shown in FIG. 4 is taken as an example for illustration, where a working phase of the structure specifically includes a first phase t_21, a second phase t_22, a third phase t_23, a fourth phase t_24, a fifth phase t_25, a sixth phase t_26.

In the first phase t_21, the signal input Input transmits a high-level signal as the input signal, and the first clock signal CK1 and the second clock signal CK2 are each at a first level, which may be considered as a low level; and the third clock signal CK3 and the fourth clock signal CK4 are each at a fourth level, which may be considered as a high level. In this case, the seventh transistor T7 is turned off, and the first transistor T1 and the third transistor T3 are turned on, so that the input signal is transmitted through the first transistor T1 and the normally-on twelfth transistor T12 to the fifth node N5, and the first node N1 and the fifth node N5 are controlled to have high potentials. Meanwhile, the first power signal is a low-level signal which is transmitted through the third transistor T3 and the normally-on eleventh transistor T11 to the fourth node N4, so that the second node N2 and the fourth node N4 are controlled to have low potentials. Accordingly, the second transistor T2, the fourth transistor T4, the seventh transistor T7, the eighth transistor T8, the ninth transistor T9 and the tenth transistor T10 are all turned off, while the output signal remains the same as in the previous phase, and, as shown in FIG. 8, maintains the low potential output of the previous phase.

In the second phase t_22, the first clock signal CK1 and the second clock signal CK2 are each at a second level, which may be considered as a high level; and the third clock signal CK3 and the fourth clock signal CK4 are each at a third level, which may be considered as a low level. In this case, the first transistor T1 and the third transistor T3 are turned off, the seventh transistor T7 is turned on, the first node N1 and the fifth node N5 maintain high potentials of the previous phase, and the second node N2 and the fourth node N4 maintain low potentials of the previous phase. Accordingly, the second transistor T2, the fourth transistor T4, the eighth transistor T8, and the tenth transistor T10 are all turned off, the fifth transistor T5 and the sixth transistor T6 are turned on, a fourth clock signal CK4 is transmitted through the turned-on sixth transistor T6 and the turned-on seventh transistor T7 to the third node N3, the third node N3 has a low potential at this time, and the ninth transistor T9 is turned on, so that a second output signal, i.e., a third power signal with a high potential, is output.

In the third phase t_23, the input signal is a high-level signal, the first clock signal CK1 and the second clock signal CK2 are each at a first level, which may be considered as a low level; and the third clock signal CK3 and the fourth clock signal CK4 are each at a fourth level, which may be considered as a high level. In this case, the seventh transistor T7 is turned off, and the third node N3 stably maintains the low potential of the previous phase. At this time, the ninth transistor T9 may remain on, so that a second output signal, i.e., a third power signal with a high potential, is output.

In the fourth period t_24, the input signal is a low-level signal, the first clock signal CK1 and the second clock signal CK2 are each at a second level, which may be considered as a high level; and the third clock signal CK3 and the fourth clock signal CK4 are each at a third level, which may be considered as a low level. In this case, the first transistor T1 and the third transistor T3 are turned off, the seventh transistor T7 is turned on, and the first node N1 and the fifth node N5 maintain high potentials of the previous phase by means of a storage function of a second capacitor C2, while the second node N2 and the fourth node N4 maintain low potentials of the previous phase. Accordingly, the second transistor T2, the fourth transistor T4, the eighth transistor T8, and the tenth transistor T10 are all turned off, the fifth transistor T5 and the sixth transistor T6 are turned on, a fourth clock signal CK4 is transmitted through the turned-on sixth transistor T6 and the turned-on seventh transistor T7 to the third node N3, the third node N3 has a low potential at this time, and the ninth transistor T9 is turned on, so that a second output signal, i.e., a third power signal with a high potential, is output.

In the fifth phase t_25, the input signal is a low-level signal, the first clock signal CK1 and the second clock signal CK2 are each at a first level, which may be considered as a low level; and the third clock signal CK3 and the fourth clock signal CK4 are each at a fourth level, which may be considered as a high level. In this case, the seventh transistor T7 is turned off, and the first transistor T1 and the second transistor T2 are turned on, so that the input signal is transmitted through the first transistor T1 and the normally-on twelfth transistor T12 to the fifth node N5, and the first node N1 and the fifth node N5 are controlled to have low potentials. Meanwhile, the first power signal is a low-level signal which is transmitted through the third transistor T3 and the normally-on eleventh transistor T11 to the fourth node N4, so that the second node N2 and the fourth node N4 are controlled to have low potentials. Accordingly, the second transistor T2, the fourth transistor T4, the fifth transistor T5, the sixth transistor T6, the eighth transistor T8, and the tenth transistor T10 are turned on, and the third node N3 is at a high level since the eighth transistor T8 is turned on, so that the ninth transistor T9 is turned off. Meanwhile, due to the influence of threshold loss, the fifth node N5 has a potential slightly higher than the second power signal, and the tenth transistor T10 is not fully turned on at this time, so that the first output signal will have a potential slightly higher than the second power signal.

In the sixth phase t_26, the input signal is a low-level signal, the first clock signal CK1 and the second clock signal CK2 are each at a second level, which may be considered as a high level; and the third clock signal CK3 and the fourth clock signal CK4 are each at a third level, which may be considered as a low level. In this case, the first transistor T1 and the third transistor T3 are turned off, the seventh transistor T7 is turned on, and the first node N1 and the fifth node N5 maintain low potentials of the previous phase by means of a storage function of a second capacitor C2, while the second node N2 and the fourth node N4 maintain low potentials of the previous phase. Accordingly, the eighth transistor T8 and the tenth transistor T10 are turned on, and a fourth power signal is transmitted through the turned-on eighth transistor T8 to the third node N3 to pull the third node N3 to a high potential, while the ninth transistor T9 is turned off. Meanwhile, by coupling of the second capacitor C2, the potential of the fifth node N5 may be reduced to be lower than the potential of the second power signal, by which the tenth transistor T10 is fully turned on, and the potential of the signal output OUT is reduced to the potential of the second power signal, that is, the first output signal.

The above is a full description of the shift register provided in the embodiments of the present disclosure.

In addition, an embodiment the present disclosure further provides a gate driver circuit, including N cascaded shift registers. Except for a first stage shift register, a signal input Input of an (i+1)^{th} stage shift register is electrically connected to a signal output OUT of an i^{th} stage shift register, where n is a positive integer greater than 1, and i is a positive integer less than or equal to N.

In some embodiments, FIG. 16 is a schematic diagram of a gate driver circuit according to an embodiment of the present disclosure. As shown in FIG. 16, a first clock signal line CKL1 in the i^{th} stage shift register is multiplexed as a fourth clock signal line CKL4 in the (i+1)^{th} stage shift register, a second clock signal line CKL2 in the i^{th} stage shift register is multiplexed as a first clock signal line CKL1 in the (i+1)^{th} stage shift register, a third clock signal line CKL3 in the i^{th} stage shift register is multiplexed as a second clock signal line CKL2 in the (i+1)^{th} stage shift register, and a fourth clock signal line CKL4 in the i^{th} stage shift register is multiplexed as a third clock signal line CKL3 in the (i+1)^{th} stage shift register.

The gate driver circuit shown in FIG. 16 is suitable for the driving timing shown in FIG. 2 or 3.

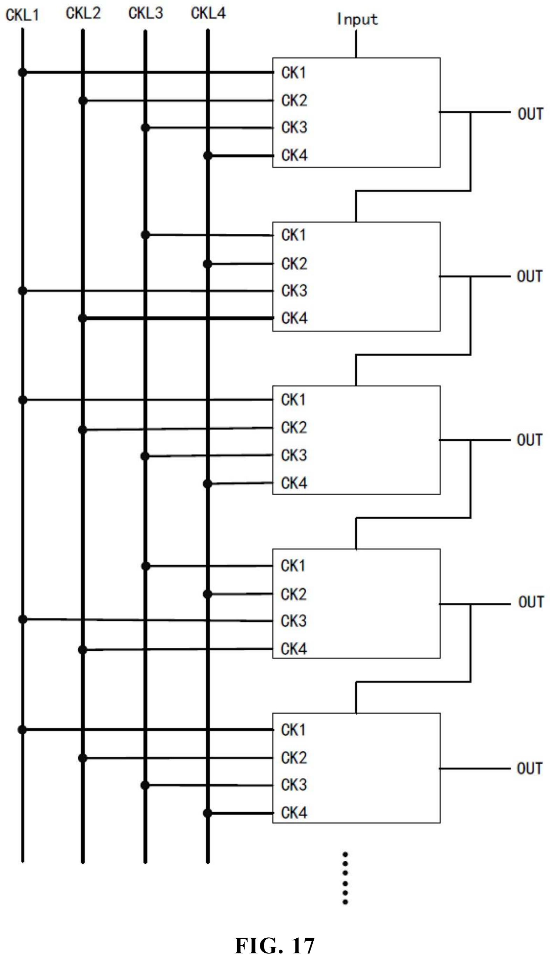

In some embodiments, FIG. 17 is a schematic diagram of another gate driver circuit according to an embodiment of the present disclosure. As shown in FIG. 17, a first clock signal line CKL1 in the i^{th} stage shift register is multiplexed as a third clock signal line CKL3 in the (i+1)^{th} stage shift register, a second clock signal line CKL2 in the i^{th} stage shift register is multiplexed as a fourth clock signal line CKL4 in the (i+1)^{th} stage shift register, a third clock signal line CKL3 in the i^{th} stage shift register is multiplexed as a first clock signal line CKL1 in the (i+1)^{th} stage shift register, and a fourth clock signal line CKL4 in the i^{th} stage shift register is multiplexed as a second clock signal line CKL2 in the (i+1)^{th} stage shift register.

The gate driver circuit shown in FIG. 17 is suitable for the driving timing shown in FIG. 4.

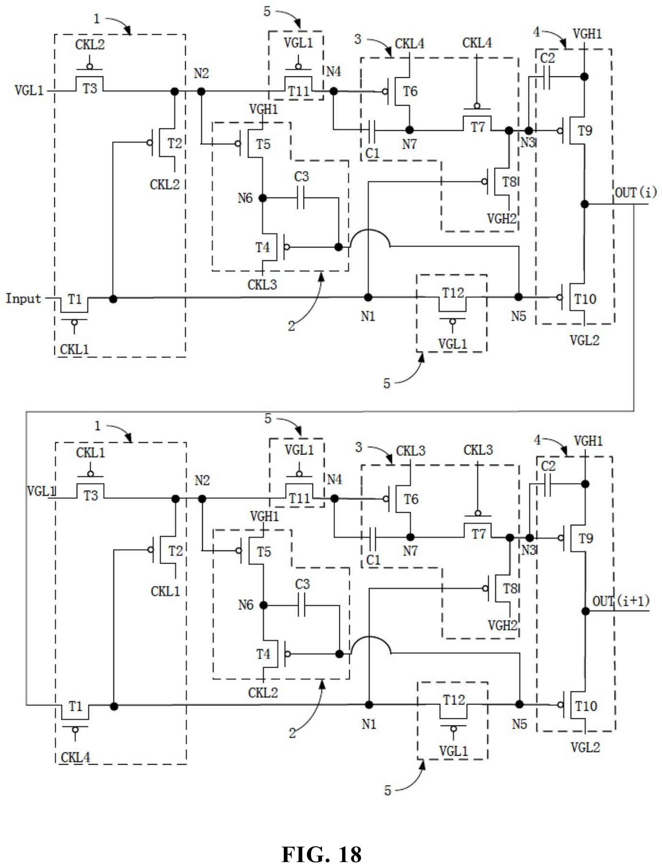

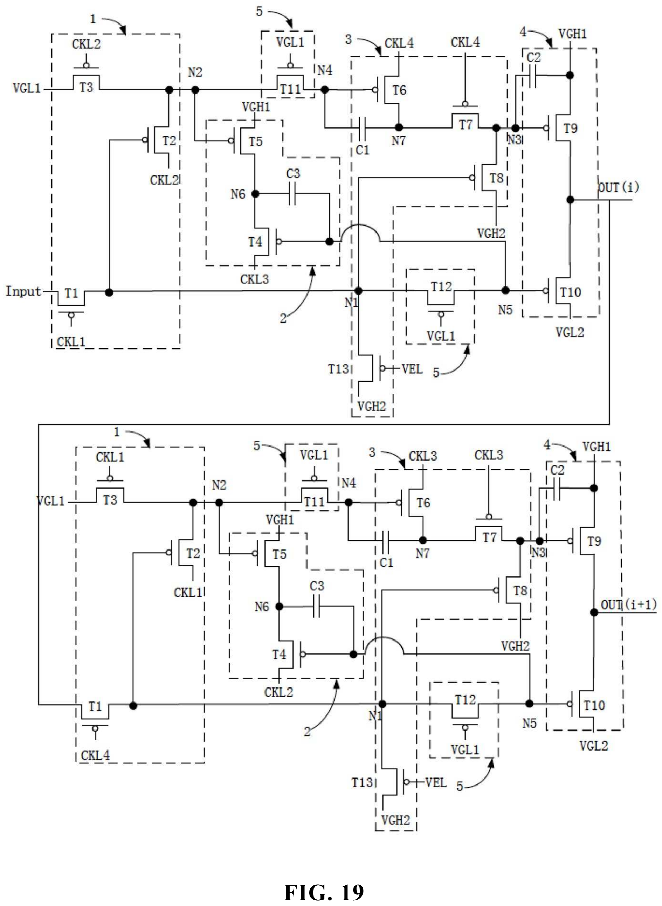

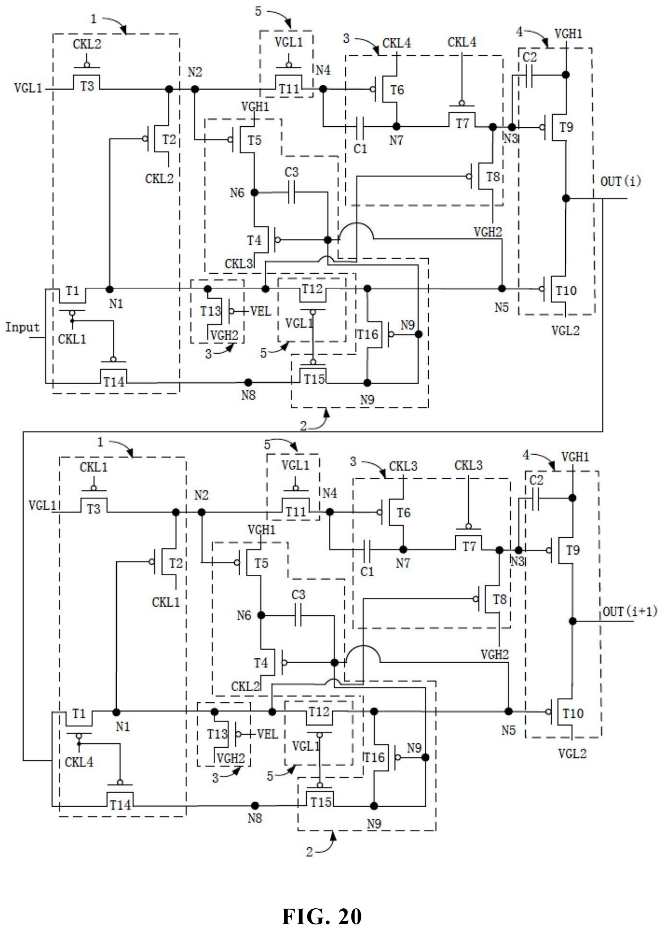

FIG. 18 is a circuit diagram of cascaded shift registers with the 12T3C circuit structure of FIG. 6 according to an embodiment of the present disclosure, FIG. 19 is a circuit diagram of cascaded shift registers with the 13T3C circuit structure of FIG. 8 according to an embodiment of the present disclosure, and FIG. 20 is a circuit diagram of cascaded shift registers with the 16T3C circuit structure of FIG. 11 according to an embodiment of the present disclosure.

In some embodiments, as shown in FIG. 18 or 19, for an i^{th} stage shift register, a control electrode of the first transistor T1 is electrically connected to the first clock signal line CKL1; a first electrode of the second transistor T2 is electrically connected to the second clock signal line CKL2; a control electrode of the third transistor T3 is electrically connected to the second clock signal line CKL2; a first electrode of the fourth transistor T4 is electrically connected to the third clock signal line CKL3; a first electrode of the sixth transistor T6 is electrically connected to the fourth clock signal line CKL4; and a control electrode of the seventh transistor T7 is electrically connected to the fourth clock signal line CKL4. For an (i+1)^{th} stage shift register cascaded with the i^{th} stage shift register, a control electrode of the first transistor T1 is electrically connected to the fourth clock signal line CKL4; a first electrode of the second transistor T2 is electrically connected to the first clock signal line CKL1; a control electrode of the third transistor T3 is electrically connected to the first clock signal line CKL1; a first electrode of the fourth transistor T4 is electrically connected to the second clock signal line CKL2; a first electrode of the sixth transistor T6 is electrically connected to the third clock signal line CKL3; and a control electrode of the seventh transistor T7 is electrically connected to the third clock signal line CKL3.

The output timing for the signal output OUT of the i^{th} stage shift register may refer to the OUT1 signal in FIG. 13, and the output timing for the signal output OUT2 of the (i+1)^{th} stage shift register may refer to the OUT2 signal in FIG. 13. Alternatively, the output timing for the signal output OUT of the i^{th} stage shift register may refer to the OUT1 signal in FIG. 14, and the output timing for the signal output OUT2 of the (i+1)^{th} stage shift register may refer to the OUT2 signal in FIG. 14.

In some embodiments, as shown in FIG. 20, for an i^{th} stage shift register, a control electrode of the first transistor T1 is electrically connected to the first clock signal line CKL1; a first electrode of the second transistor T2 is electrically connected to the second clock signal line CKL2; a control electrode of the third transistor T3 is electrically connected to the second clock signal line CKL2; a control electrode of the fourteenth transistor T14 is electrically connected to the first clock signal line CKL1; a first electrode of the fourth transistor T4 is electrically connected to the third clock signal line CKL3; a first electrode of the sixth transistor T6 is electrically connected to the fourth clock signal line CKL4; and a control electrode of the seventh transistor T7 is electrically connected to the fourth clock signal line CKL4. For an (i+1)^{th} stage shift register cascaded with the i^{th} stage shift register, a control electrode of the first transistor T1 is electrically connected to the fourth clock signal line CKL4; a first electrode of the second transistor T2 is electrically connected to the first clock signal line CKL1; a control electrode of the third transistor T3 is electrically connected to the first clock signal line CKL1; a control electrode of the fourteenth transistor T14 is electrically connected to the fourth clock signal line CKL4; a first electrode of the fourth transistor T4 is electrically connected to the second clock signal line CKL2; a first electrode of the sixth transistor T6 is electrically connected to the third clock signal line CKL3; and a control electrode of the seventh transistor T7 is electrically connected to the third clock signal line CKL3.

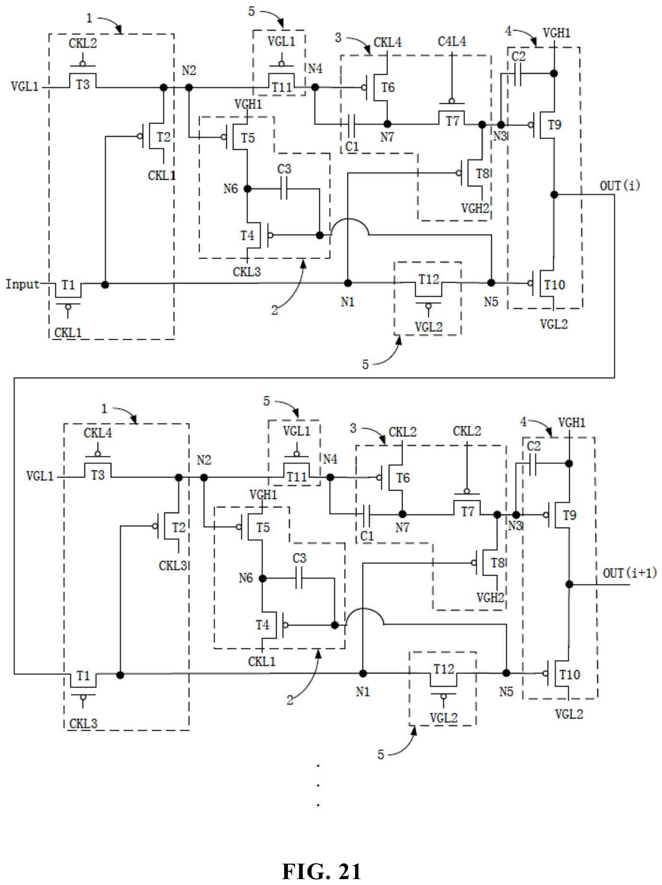

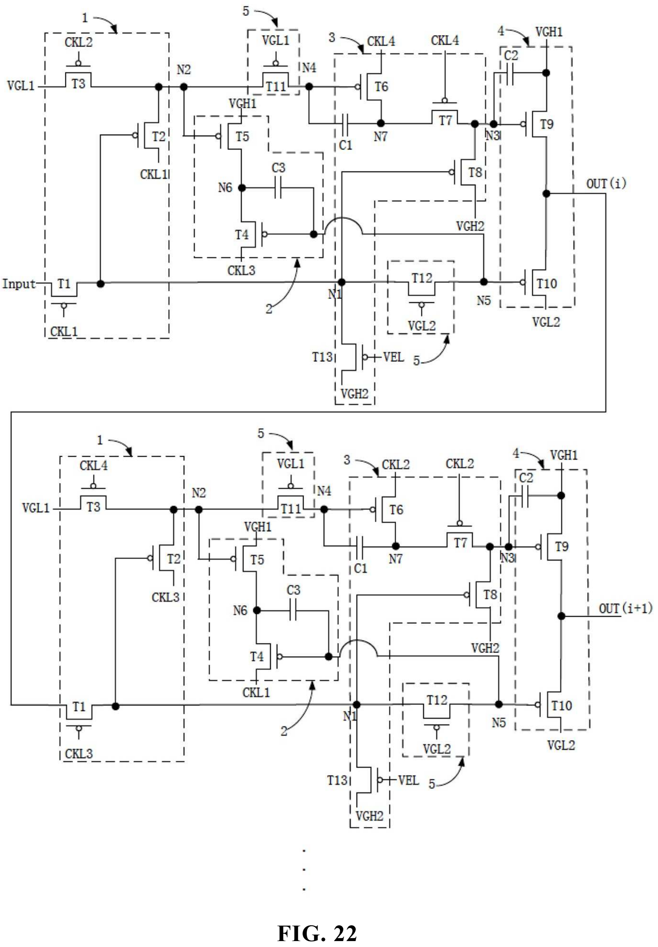

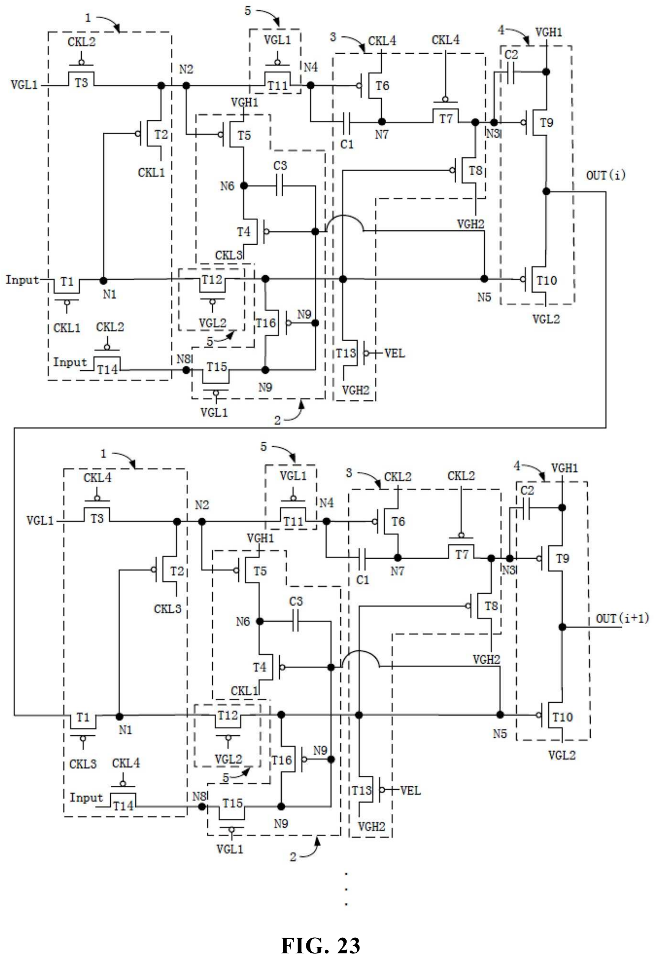

FIG. 21 is a circuit diagram of cascaded shift registers with the 12T3C circuit structure of FIG. 7 according to an embodiment of the present disclosure, FIG. 22 is a circuit diagram of cascaded shift registers with the 13T3C circuit structure of FIG. 9 according to an embodiment of the present disclosure, and FIG. 23 is a circuit diagram of cascaded shift registers with the 16T3C circuit structure of FIG. 12 according to an embodiment of the present disclosure.

In some embodiments, as shown in FIG. 21 or 22, for an i^{th} stage shift register, a control electrode of the first transistor T1 is electrically connected to the first clock signal line CKL1; a first electrode of the second transistor T2 is electrically connected to the first clock signal line CKL1; a control electrode of the third transistor T3 is electrically connected to the second clock signal line CKL2; a first electrode of the fourth transistor T4 is electrically connected to the third clock signal line CKL3; a first electrode of the sixth transistor T6 is electrically connected to the fourth clock signal line CKL4; and a control electrode of the seventh transistor T7 is electrically connected to the fourth clock signal line CKL4. For an (i+1)^{th} stage shift register cascaded with the i^{th} stage shift register, a control electrode of the first transistor T1 is electrically connected to the third clock signal line CKL3; a first electrode of the second transistor T2 is electrically connected to the third clock signal line CKL3; a control electrode of the third transistor T3 is electrically connected to the fourth clock signal line CKL4; a first electrode of the fourth transistor T4 is electrically connected to the first clock signal line CKL1; a first electrode of the sixth transistor T6 is electrically connected to the second clock signal line CKL2; and a control electrode of the seventh transistor T7 is electrically connected to the second clock signal line CKL2.

In some embodiments, as shown in FIG. 23, for an i^{th} stage shift register, a control electrode of the first transistor T1 is electrically connected to the first clock signal line CKL1; a first electrode of the second transistor T2 is electrically connected to the first clock signal line CKL1; a control electrode of the third transistor T3 is electrically connected to the second clock signal line CKL2; a control electrode of the fourteenth transistor T14 is electrically connected to the second clock signal line CKL2; a first electrode of the fourth transistor T4 is electrically connected to the third clock signal line CKL3; a first electrode of the sixth transistor T6 is electrically connected to the fourth clock signal line CKL4; and a control electrode of the seventh transistor T7 is electrically connected to the fourth clock signal line CKL4. For an (i+1)^{th} stage shift register cascaded with the i^{th} stage shift register, a control electrode of the first transistor T1 is electrically connected to the third clock signal line CKL3; a first electrode of the second transistor T2 is electrically connected to the third clock signal line CKL3; a control electrode of the third transistor T3 is electrically connected to the fourth clock signal line CKL4; a control electrode of the fourteenth transistor T14 is electrically connected to the fourth clock signal line CKL4; a first electrode of the fourth transistor T4 is electrically connected to the first clock signal line CKL1; a first electrode of the sixth transistor T6 is electrically connected to the second clock signal line CKL2; and a control electrode of the seventh transistor T7 is electrically connected to the second clock signal line CKL2.

Since the cascaded i^{th} stage shift register and (i+1)^{th} shift register in the gate driver circuit are electrically connected to a set of clock signals with different timings, i.e., the first clock signal CK1 and the second clock signal CK2 having different timings from the third clock signal CK3 and the fourth clock signal CK4, the timings of the two are not affected.

In addition, an embodiment the present disclosure further provides a display apparatus, including a pixel drive circuit and any gate driver circuit as described above. The gate driver circuit is electrically connected to the pixel driver circuit to provide a gate control signal for the pixel driver circuit.

Illustratively, the display apparatus may be, for example, a mobile phone, a tablet, a television, a monitor, a laptop, a digital album, a vehicle-mounted device or any other product having a display function. Other essential components of the display apparatus are regarded as present by those skilled in the art, which are not described herein and should not be construed as limiting the present disclosure.

It will be appreciated that the above implementations are merely exemplary implementations for the purpose of illustrating the principle of the present disclosure, and the present disclosure is not limited thereto. Various modifications and improvements can be made by those skilled in the art without departing from the spirit and essence of the disclosure. Accordingly, all of the modifications and improvements also fall into the protection scope of the present disclosure.

## Claims

1. A shift register, **characterized by** comprising a first clock signal line, a second clock signal line, a third clock signal line, a fourth clock signal line, an input sub-circuit, a first control sub-circuit, a second control sub-circuit, and an output sub-circuit; wherein
the input sub-circuit is configured to control potentials of a first node and a second node in response to a first clock signal provided via the first clock signal line and a second clock signal provided via the second clock signal line;
the first control sub-circuit is configured to control the potential of the first node in response to a signal of the second node and a third clock signal provided via the third clock signal line;
the second control sub-circuit is configured to control a potential of a third node in response to a signal of the first node, the signal of the second node, and a fourth clock signal provided via the fourth clock signal line; and
the output sub-circuit is configured to output a first output signal in response to the signal of the first node, or output a second output signal in response to the signal of the third node.

2. The shift register according to claim 1, wherein in one clock cycle, the first clock signal has a pulse preceding a pulse of the second clock signal, the second clock signal has the pulse preceding a pulse of the third clock signal, and the third clock signal has the pulse preceding a pulse of the fourth clock signal.

3. The shift register according to claim 1, wherein in one clock cycle, the first clock signal has a pulse preceding a pulse of the second clock signal, the second clock signal has the pulse preceding a pulse of the fourth clock signal, and the fourth clock signal has the pulse preceding a pulse of the third clock signal.

4. The shift register according to claim 1, wherein the first clock signal has the same timing as the second clock signal; the third clock signal has an opposite timing to the first clock signal; and the fourth clock signal has the same timing as the third clock signal.

5. The shift register according to claim 4, wherein the first clock signal and the second clock signal each comprise a first level; and the first level of the first clock signal has a different potential from the first level of the second clock signal; and/or,
the third clock signal and the fourth clock signal each comprise a third level; and the third level of the third clock signal has a different potential from the third level of the fourth clock signal.

6. The shift register according to claim 5, wherein the first level of the first clock signal has a potential lower than the first level of the second clock signal; and/or,
the third level of the third clock signal has a potential lower than the third level of the fourth clock signal.

7. The shift register according to claim 5, wherein the first clock signal and the second clock signal each further comprise a second level different from the first level; and the second level of the first clock signal has a different potential from the second level of the second clock signal; and/or,
the third clock signal and the fourth clock signal each further comprise a fourth level different from the third level; and the fourth level of the third clock signal has a different potential from the fourth level of the fourth clock signal.

8. The shift register according to claim 7, wherein the second level of the first clock signal has a potential higher than the second level of the second clock signal; and/or,
the fourth level of the third clock signal has a potential higher than the fourth level of the fourth clock signal.

9. The shift register according to any one of claims 1 to 8, wherein the shift register further comprises a first power signal line, a second power signal line, a third power signal line, and a fourth power signal line; wherein
the input sub-circuit is electrically connected to the first power signal line, the first control sub-circuit is electrically connected to the third power signal line, the second control sub-circuit is electrically connected to the fourth power signal line, and the output sub-circuit is electrically connected to the second power signal line and the third power signal line.

10. The shift register according to claim 9, wherein a first power signal transmitted via the first power signal line has a potential lower than a second power signal transmitted via the second power signal line; a third power signal transmitted via the third power signal line has a potential lower than a fourth power signal transmitted via the fourth power signal line; and the second power signal has a potential lower than the third power signal.

11. The shift register according to claim 10, wherein the first level of the first clock signal has a potential equal to the first power signal, and the second level of the first clock signal has a potential equal to the fourth power signal;
the first level of the second clock signal has a potential equal to the second power signal, and the second level of the second clock signal has a potential equal to the third power signal;
the third level of the third clock signal has a potential equal to the first power signal, and the fourth level of the third clock signal has a potential equal to the fourth power signal; and
the third level of the fourth clock signal has a potential equal to the second power signal, and the third level of the fourth clock signal has a potential equal to the third power signal.

12. The shift register according to any one of claims 4 to 8, wherein the first clock signal has a smaller pulse width for the first level than for the second level; and/or, the third clock signal has a smaller pulse width for the third level than for the fourth level.

13. The shift register according to any one of claims 1 to 3, wherein the input sub-circuit comprises a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line.

14. The shift register according to any one of claims 1 to 8, wherein the input sub-circuit comprises a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the first clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line.

15. The shift register according to any one of claims 1 to 8, wherein the input sub-circuit comprises a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the first clock signal line.

16. The shift register according to any one of claims 1 to 8, wherein the shift register further comprises an isolation sub-circuit;
the isolation sub-circuit is configured to isolate the first node from the first control sub-circuit electrically connected to the first node; isolate the first node from the output sub-circuit electrically connected to the first node; and isolate the second node from the second control sub-circuit electrically connected to the second node; and
the first control sub-circuit is electrically connected to a fifth node; the output sub-circuit is electrically connected to the fifth node; and the second control sub-circuit is electrically connected to a fourth node.

17. The shift register according to claim 16, wherein the isolation sub-circuit comprises an eleventh transistor and a twelfth transistor;
the eleventh transistor has a first electrode electrically connected to the second node, a second electrode electrically connected to the fourth node, and a control electrode electrically connected to a first power signal line; and
the twelfth transistor has a first electrode electrically connected to the first node, a second electrode electrically connected to the fifth node, and a control electrode electrically connected to a second power signal line.

18. The shift register according to claim 16, wherein the isolation sub-circuit comprises an eleventh transistor and a twelfth transistor; wherein
the eleventh transistor has a first electrode electrically connected to the second node, a second electrode electrically connected to the fourth node, and a control electrode electrically connected to a first power signal line; and
the twelfth transistor has a first electrode electrically connected to the first node, a second electrode electrically connected to the fifth node, and a control electrode electrically connected to a first power signal line.

19. The shift register according to claim 16, wherein the first control sub-circuit comprises a fourth transistor, a fifth transistor, and a third capacitor;
the fourth transistor has a first electrode electrically connected to the third clock signal line, a second electrode electrically connected to a second electrode of the fifth transistor, and a control electrode electrically connected to the fifth node; and
the fifth transistor has a first electrode electrically connected to a third power signal line, the second electrode electrically connected to a first plate of the third capacitor, and a control electrode electrically connected to the second node; and
the third capacitor has a second plate electrically connected to the fifth node.

20. The shift register according to claim 16, wherein the second control sub-circuit comprises a sixth transistor, a seventh transistor, an eighth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line; and
the eighth transistor has a first electrode electrically connected to a fourth power signal line, a second electrode electrically connected to the third node, and a control electrode electrically connected to the first node.

21. The shift register according to claim 16, wherein the second control sub-circuit comprises a sixth transistor, a seventh transistor, an eighth transistor, a thirteenth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the capacitor;
the seventh transistor has the first electrode electrically connected to a second plate of the first capacitor, a second electrode electrically connected to the third node, and a control electrode electrically connected to the fourth clock signal line;
the eighth transistor has a first electrode electrically connected to a fourth power signal line, a second electrode electrically connected to the third node, and a control electrode electrically connected to the first node; and
the thirteenth transistor has a first electrode electrically connected to the fourth power signal line, a second electrode electrically connected to the first node, and a control electrode electrically connected to a preset control terminal.

22. The shift register according to claim 16, wherein the input sub-circuit comprises a first transistor, a second transistor, a third transistor, and a fourteenth transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node;
the third transistor has a first electrode electrically connected to a first power signal line, a second electrode electrically connected to the second node, and a control electrode electrically connected to the second clock signal line; and
the fourteenth transistor has a first electrode electrically connected to a signal input, a second electrode electrically connected to an eighth node, and a control electrode electrically connected to the first clock signal line.

23. The shift register according to any one of claims 1 to 8, wherein the shift register further comprises an isolation sub-circuit;
the isolation sub-circuit is configured to isolate the first node from the first control sub-circuit electrically connected to the first node; isolate the first node from the output sub-circuit electrically connected to the first node; isolate the first node from the second control sub-circuit electrically connected to the first node; and isolate the second node from the second control sub-circuit electrically connected to the second node; and
the first control sub-circuit is electrically connected to a fifth node; the output sub-circuit is electrically connected to the fifth node; and the second control sub-circuit is electrically connected to a fourth node and the fifth node.

24. The shift register according to claim 23, wherein the input sub-circuit comprises a first transistor, a second transistor, a third transistor, and a fourteenth transistor;
the first transistor has a first electrode electrically connected to a signal input, a second electrode electrically connected to the first node, and a control electrode electrically connected to the first clock signal line;
the second transistor has a first electrode electrically connected to the first clock signal line, a second electrode electrically connected to the second node, and a control electrode electrically connected to the first node;
the third transistor has a first electrode electrically connected to a first power signal line, a second electrode electrically connected to the second node, and a control electrode electrically connected to the second clock signal line; and
the fourteenth transistor has a first electrode electrically connected to a signal input, a second electrode electrically connected to an eighth node, and a control electrode electrically connected to the second clock signal line.

25. The shift register according to claim 24, wherein the first control sub-circuit comprises a fourth transistor, a fifth transistor, a fifteenth transistor, a sixteenth transistor, and a third capacitor;
the fourth transistor has a first electrode electrically connected to the third clock signal line, a second electrode electrically connected to a second electrode of the fifth transistor, and a control electrode electrically connected to a second plate of the third capacitor;
the fifth transistor has a first electrode electrically connected to a third power signal line, the second electrode electrically connected to a first plate of the third capacitor, and a control electrode electrically connected to the second node;
the fifteenth transistor has a first electrode electrically connected to the eighth node, a second electrode electrically connected a first electrode and a control electrode of the sixteenth transistor, and a control electrode electrically connected to a first power signal line; and
the sixteenth transistor has a second electrode electrically connected to the fifth node, and the control electrode electrically connected to the control electrode of the fourth transistor.

26. The shift register according to claim 25, wherein the second control sub-circuit comprises a sixth transistor, a seventh transistor, an eighth transistor, a thirteenth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line;
the eighth transistor has a first electrode electrically connected to a fourth power signal line, a second electrode electrically connected to the third node, and a control electrode electrically connected to the fifth node; and
the thirteenth transistor has a first electrode electrically connected to the fourth power signal line, a second electrode electrically connected to the fifth node, and a control electrode electrically connected to a preset control terminal.

27. The shift register according to claim 23, wherein the output sub-circuit comprises a ninth transistor, a tenth transistor, and a second capacitor;
the ninth transistor has a first electrode electrically connected to a third power signal line and a first plate of the second capacitor, a second electrode electrically connected to a signal output, and a control electrode electrically connected to the third node;
the tenth transistor has a first electrode electrically connected to a second power signal line, a second electrode electrically connected to the signal output, and a control electrode electrically connected to the fifth node; and
the second capacitor has a second plate electrically connected to the third node.

28. A gate driver circuit, comprising N cascaded shift registers; wherein except for a first stage shift register, a signal input of an (i+1)^{th} stage shift register is electrically connected to a signal output of an ith stage shift register, where n is a positive integer greater than 1, and i is a positive integer less than or equal to N.

29. The gate driver circuit according to claim 28, wherein a first clock signal line in the i^{th} stage shift register is multiplexed as a fourth clock signal line in the (i+1)^{th} stage shift register, a second clock signal line in the i^{th} stage shift register is multiplexed as a first clock signal line in the (i+1)^{th} stage shift register, a third clock signal line in the i^{th} stage shift register is multiplexed as a second clock signal line in the (i+1)^{th} stage shift register, and a fourth clock signal line in the i^{th} stage shift register is multiplexed as a third clock signal line in the (i+1)^{th} stage shift register.

30. The gate driver circuit according to claim 28, wherein a first clock signal line in the i^{th} stage shift register is multiplexed as a third clock signal line in the (i+1)^{th} stage shift register, a second clock signal line in the i^{th} stage shift register is multiplexed as a fourth clock signal line in the (i+1)^{th} stage shift register, a third clock signal line in the i^{th} stage shift register is multiplexed as a first clock signal line in the (i+1)^{th} stage shift register, and a fourth clock signal line in the i^{th} stage shift register is multiplexed as a second clock signal line in the (i+1)^{th} stage shift register.

31. A display apparatus, comprising a pixel driver circuit and a gate driver circuit according to any one of claims 28 to 30, wherein the gate driver circuit is electrically connected to the pixel driver circuit to provide a gate control signal for the pixel driver circuit.

## Amended claims

### Amended claims under Art. 19.1 PCT

1. A shift register, **characterized by** comprising a first clock signal line, a second clock signal line, a third clock signal line, a fourth clock signal line, an input sub-circuit, a first control sub-circuit, a second control sub-circuit, and an output sub-circuit; wherein
the input sub-circuit is configured to control potentials of a first node and a second node in response to a first clock signal provided via the first clock signal line and a second clock signal provided via the second clock signal line;
the first control sub-circuit is configured to control the potential of the first node in response to a signal of the second node and a third clock signal provided via the third clock signal line;
the second control sub-circuit is configured to control a potential of a third node in response to a signal of the first node, the signal of the second node, and a fourth clock signal provided via the fourth clock signal line; and
the output sub-circuit is configured to output a first output signal in response to the signal of the first node, or output a second output signal in response to the signal of the third node.

2. The shift register according to claim 1, wherein in one clock cycle, the first clock signal has a pulse preceding a pulse of the second clock signal, the second clock signal has the pulse preceding a pulse of the third clock signal, and the third clock signal has the pulse preceding a pulse of the fourth clock signal.

3. The shift register according to claim 1, wherein in one clock cycle, the first clock signal has a pulse preceding a pulse of the second clock signal, the second clock signal has the pulse preceding a pulse of the fourth clock signal, and the fourth clock signal has the pulse preceding a pulse of the third clock signal.

4. The shift register according to claim 1, wherein the first clock signal has the same timing as the second clock signal; the third clock signal has an opposite timing to the first clock signal; and the fourth clock signal has the same timing as the third clock signal.

5. The shift register according to claim 4, wherein the first clock signal and the second clock signal each comprise a first level; and the first level of the first clock signal has a different potential from the first level of the second clock signal; and/or,
the third clock signal and the fourth clock signal each comprise a third level; and the third level of the third clock signal has a different potential from the third level of the fourth clock signal.

6. The shift register according to claim 5, wherein the first level of the first clock signal has a potential lower than the first level of the second clock signal; and/or,
the third level of the third clock signal has a potential lower than the third level of the fourth clock signal.

7. The shift register according to claim 5, wherein the first clock signal and the second clock signal each further comprise a second level different from the first level; and the second level of the first clock signal has a different potential from the second level of the second clock signal; and/or,
the third clock signal and the fourth clock signal each further comprise a fourth level different from the third level; and the fourth level of the third clock signal has a different potential from the fourth level of the fourth clock signal.

8. The shift register according to claim 7, wherein the second level of the first clock signal has a potential higher than the second level of the second clock signal; and/or,
the fourth level of the third clock signal has a potential higher than the fourth level of the fourth clock signal.

9. [Amended] The shift register according to any one of claims 1 to 8, wherein the shift register further comprises a first power signal line, a second power signal line, a third power signal line, and a fourth power signal line; wherein
the input sub-circuit is electrically connected to the first power signal line, the first control sub-circuit is electrically connected to the third power signal line or the fourth power signal line, the second control sub-circuit is electrically connected to the fourth power signal line, and the output sub-circuit is electrically connected to the second power signal line and the third power signal line.

10. The shift register according to claim 9, wherein a first power signal transmitted via the first power signal line has a potential lower than a second power signal transmitted via the second power signal line; a third power signal transmitted via the third power signal line has a potential lower than a fourth power signal transmitted via the fourth power signal line; and the second power signal has a potential lower than the third power signal.

11. The shift register according to claim 10, wherein the first level of the first clock signal has a potential equal to the first power signal, and the second level of the first clock signal has a potential equal to the fourth power signal;
the first level of the second clock signal has a potential equal to the second power signal, and the second level of the second clock signal has a potential equal to the third power signal;
the third level of the third clock signal has a potential equal to the first power signal, and the fourth level of the third clock signal has a potential equal to the fourth power signal; and
the third level of the fourth clock signal has a potential equal to the second power signal, and the third level of the fourth clock signal has a potential equal to the third power signal.

12. The shift register according to any one of claims 4 to 8, wherein the first clock signal has a smaller pulse width for the first level than for the second level; and/or, the third clock signal has a smaller pulse width for the third level than for the fourth level.

13. The shift register according to any one of claims 1 to 3, wherein the input sub-circuit comprises a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line.

14. The shift register according to any one of claims 1 to 8, wherein the input sub-circuit comprises a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the first clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the second clock signal line.

15. The shift register according to any one of claims 1 to 8, wherein the input sub-circuit comprises a first transistor, a second transistor and a third transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node; and
the third transistor has a first electrode electrically connected to a first power signal line, a second electrode electrically connected to the second node, and a control electrode electrically connected to the first clock signal line.

16. The shift register according to any one of claims 1 to 8, wherein the shift register further comprises an isolation sub-circuit;
the isolation sub-circuit is configured to isolate the first node from the first control sub-circuit electrically connected to the first node; isolate the first node from the output sub-circuit electrically connected to the first node; and isolate the second node from the second control sub-circuit electrically connected to the second node; and
the first control sub-circuit is electrically connected to a fifth node; the output sub-circuit is electrically connected to the fifth node; and the second control sub-circuit is electrically connected to a fourth node.

17. The shift register according to claim 16, wherein the isolation sub-circuit comprises an eleventh transistor and a twelfth transistor;
the eleventh transistor has a first electrode electrically connected to the second node, a second electrode electrically connected to the fourth node, and a control electrode electrically connected to a first power signal line; and
the twelfth transistor has a first electrode electrically connected to the first node, a second electrode electrically connected to the fifth node, and a control electrode electrically connected to a second power signal line.

18. The shift register according to claim 16, wherein the isolation sub-circuit comprises an eleventh transistor and a twelfth transistor; wherein
the eleventh transistor has a first electrode electrically connected to the second node, a second electrode electrically connected to the fourth node, and a control electrode electrically connected to a first power signal line; and
the twelfth transistor has a first electrode electrically connected to the first node, a second electrode electrically connected to the fifth node, and a control electrode electrically connected to a first power signal line.

19. [Amended] The shift register according to claim 16, wherein the first control sub-circuit comprises a fourth transistor, a fifth transistor, and a third capacitor;
the fourth transistor has a first electrode electrically connected to the third clock signal line, a second electrode electrically connected to a second electrode of the fifth transistor, and a control electrode electrically connected to the fifth node; and
the fifth transistor has a first electrode electrically connected to a third power signal line or a fourth power signal line, the second electrode electrically connected to a first plate of the third capacitor, and a control electrode electrically connected to the second node; and
the third capacitor has a second plate electrically connected to the fifth node.

20. The shift register according to claim 16, wherein the second control sub-circuit comprises a sixth transistor, a seventh transistor, an eighth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line; and
the eighth transistor has a first electrode electrically connected to a fourth power signal line, a second electrode electrically connected to the third node, and a control electrode electrically connected to the first node.

21. [Amended] The shift register according to claim 16, wherein the second control sub-circuit comprises a sixth transistor, a seventh transistor, an eighth transistor, a thirteenth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line;
the eighth transistor has a first electrode electrically connected to a fourth power signal line, a second electrode electrically connected to the third node, and a control electrode electrically connected to the first node; and
the thirteenth transistor has a first electrode electrically connected to the fourth power signal line, a second electrode electrically connected to the first node, and a control electrode electrically connected to a preset control terminal.

22. [New Added] The shift register according to claim 16, wherein the output sub-circuit comprises a ninth transistor, a tenth transistor, and a second capacitor;
the ninth transistor has a first electrode electrically connected to a third power signal line and a first plate of the second capacitor, a second electrode electrically connected to a signal output, and a control electrode electrically connected to the third node;
the tenth transistor has a first electrode electrically connected to a second power signal line, a second electrode electrically connected to the signal output, and a control electrode electrically connected to the fifth node; and
the second capacitor has a second plate electrically connected to the third node.

23. The shift register according to claim 16, wherein the input sub-circuit comprises a first transistor, a second transistor, a third transistor, and a fourteenth transistor;
the first transistor has a first electrode electrically connected to a signal input, a second electrode electrically connected to the first node, and a control electrode electrically connected to the first clock signal line;
the second transistor has a first electrode electrically connected to the second clock signal line, a second electrode electrically connected to the second node, and a control electrode electrically connected to the first node;
the third transistor has a first electrode electrically connected to a first power signal line, a second electrode electrically connected to the second node, and a control electrode electrically connected to the second clock signal line; and
the fourteenth transistor has a first electrode electrically connected to a signal input, a second electrode electrically connected to an eighth node, and a control electrode electrically connected to the first clock signal line.

24. The shift register according to any one of claims 1 to 8, wherein the shift register further comprises an isolation sub-circuit;
the isolation sub-circuit is configured to isolate the first node from the first control sub-circuit electrically connected to the first node; isolate the first node from the output sub-circuit electrically connected to the first node; isolate the first node from the second control sub-circuit electrically connected to the first node; and isolate the second node from the second control sub-circuit electrically connected to the second node; and
the first control sub-circuit is electrically connected to a fifth node; the output sub-circuit is electrically connected to the fifth node; and the second control sub-circuit is electrically connected to a fourth node and the fifth node.

25. [Amended] The shift register according to claim 24, wherein the input sub-circuit comprises a first transistor, a second transistor, a third transistor, and a fourteenth transistor;
the first transistor has a first electrode electrically connected to a signal input, a second electrode electrically connected to the first node, and a control electrode electrically connected to the first clock signal line;
the second transistor has a first electrode electrically connected to the first clock signal line, a second electrode electrically connected to the second node, and a control electrode electrically connected to the first node;
the third transistor has a first electrode electrically connected to a first power signal line, a second electrode electrically connected to the second node, and a control electrode electrically connected to the second clock signal line; and
the fourteenth transistor has a first electrode electrically connected to a signal input, a second electrode electrically connected to an eighth node, and a control electrode electrically connected to the second clock signal line.

26. [Amended] The shift register according to claim 25, wherein the first control sub-circuit comprises a fourth transistor, a fifth transistor, a fifteenth transistor, a sixteenth transistor, and a third capacitor;
the fourth transistor has a first electrode electrically connected to the third clock signal line, a second electrode electrically connected to a second electrode of the fifth transistor, and a control electrode electrically connected to a second plate of the third capacitor;
the fifth transistor has a first electrode electrically connected to a third power signal line or a fourth power signal line, the second electrode electrically connected to a first plate of the third capacitor, and a control electrode electrically connected to the second node;
the fifteenth transistor has a first electrode electrically connected to the eighth node, a second electrode electrically connected a first electrode and a control electrode of the sixteenth transistor, and a control electrode electrically connected to a first power signal line; and
the sixteenth transistor has a second electrode electrically connected to the fifth node, and the control electrode electrically connected to the control electrode of the fourth transistor.

27. [Amended] The shift register according to claim 26, wherein the second control sub-circuit comprises a sixth transistor, a seventh transistor, an eighth transistor, a thirteenth transistor, and a first capacitor;
the sixth transistor has a first electrode electrically connected to the fourth clock signal line, a second electrode electrically connected to a first electrode of the seventh transistor, and a control electrode electrically connected to the fourth node and a first plate of the first capacitor;
the seventh transistor has the first electrode electrically connected to a second plate of the first capacitor, a second electrode electrically connected to the third node, and a control electrode electrically connected to the fourth clock signal line;
the eighth transistor has a first electrode electrically connected to a fourth power signal line, a second electrode electrically connected to the third node, and a control electrode electrically connected to the fifth node; and
the thirteenth transistor has a first electrode electrically connected to the fourth power signal line, a second electrode electrically connected to the fifth node, and a control electrode electrically connected to a preset control terminal.

28. [Amended] The shift register according to claim 24, wherein the output sub-circuit comprises a ninth transistor, a tenth transistor, and a second capacitor;
the ninth transistor has a first electrode electrically connected to a third power signal line and a first plate of the second capacitor, a second electrode electrically connected to a signal output, and a control electrode electrically connected to the third node;
the tenth transistor has a first electrode electrically connected to a second power signal line, a second electrode electrically connected to the signal output, and a control electrode electrically connected to the fifth node; and
the second capacitor has a second plate electrically connected to the third node.

29. A gate driver circuit, comprising N cascaded shift registers; wherein except for a first stage shift register, a signal input of an (i+1)^{th} stage shift register is electrically connected to a signal output of an ith stage shift register, where n is a positive integer greater than 1, and i is a positive integer less than or equal to N.

30. [Amended] The gate driver circuit according to claim 29, wherein a first clock signal line in the i^{th} stage shift register is multiplexed as a fourth clock signal line in the (i+1)^{th} stage shift register, a second clock signal line in the i^{th} stage shift register is multiplexed as a first clock signal line in the (i+1)^{th} stage shift register, a third clock signal line in the i^{th} stage shift register is multiplexed as a second clock signal line in the (i+1)^{th} stage shift register, and a fourth clock signal line in the i^{th} stage shift register is multiplexed as a third clock signal line in the (i+1)^{th} stage shift register.

31. [Amended] The gate driver circuit according to claim 29, wherein a first clock signal line in the i^{th} stage shift register is multiplexed as a third clock signal line in the (i+1)^{th} stage shift register, a second clock signal line in the i^{th} stage shift register is multiplexed as a fourth clock signal line in the (i+1)^{th} stage shift register, a third clock signal line in the i^{th} stage shift register is multiplexed as a first clock signal line in the (i+1)^{th} stage shift register, and a fourth clock signal line in the i^{th} stage shift register is multiplexed as a second clock signal line in the (i+1)^{th} stage shift register.

32. [Amended] A display apparatus, comprising a pixel driver circuit and a gate driver circuit according to any one of claims 29 to 31, wherein the gate driver circuit is electrically connected to the pixel driver circuit to provide a gate control signal for the pixel driver circuit.
